(19) **Europäisches Patentamt**
**European Patent Office**
**Office européen des brevets**

(11) **EP 2 415 193 B1**

(12) **FASCICULE DE BREVET EUROPEEN**

(45) Date de publication et mention
de la délivrance du brevet:
**10.01.2018 Bulletin 2018/02**

(21) Numéro de dépôt: **10712446.3**

(22) Date de dépôt: **02.04.2010**

(51) Int Cl.:
***H04L 1/00*** *(2006.01)*

(86) Numéro de dépôt international:
**PCT/EP2010/054467**

(87) Numéro de publication internationale:
**WO 2010/112606 (07.10.2010 Gazette 2010/40)**

(54) **PROCÉDÉ ET DISPOSITIF DE MODULATION METTANT EN OEUVRE UNE MODULATION DIFFÉRENTIELLE, PROCÉDÉ ET DISPOSITIF DE DÉMODULATION, SIGNAL ET PRODUITS PROGRAMME D'ORDINATEUR CORRESPONDANTS**

MODULATIONSVERFAHREN UND VORRICHTUNG ZUR DURCHFÜHRUNG EINER DIFFERENZMODULATION UND ENTSPRECHENDE(S) DEMODULATIONSVERFAHREN UND VORRICHTUNG, SIGNAL UND RECHNERPROGRAMMPRODUKTE

MODULATION METHOD AND DEVICE IMPLEMENTING A DIFFERENTIAL MODULATION, AND CORRESPONDING DEMODULATION METHOD AND DEVICE, SIGNAL, AND COMPUTER PROGRAM PRODUCTS

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **03.04.2009 FR 0952207**

(43) Date de publication de la demande:
**08.02.2012 Bulletin 2012/06**

(73) Titulaire: **Institut Telecom - Telecom Paristech 75014 Paris (FR)**

(72) Inventeurs:
• **MUMTAZ, Sami**
**F-78390 Bois D'arcy (FR)**
• **REKAYA-BEN OTHMAN, Ghaya**
**F-92160 Antony (FR)**
• **JAOUËN, Yves**
**F-75019 Paris (FR)**

(74) Mandataire: **Hnich-Gasri, Naïma**
**Marks & Clerk France**
**Immeuble Visium**
**22, avenue Aristide Briand**
**94117 Arcueil Cedex (FR)**

(56) Documents cités:
**EP-A- 0 777 354       EP-A1- 1 501 198**
**WO-A-2008/009627    US-A- 3 891 959**

EP 2 415 193 B1

**Description**

**1. Domaine de l'invention**

Le domaine de l'invention est celui des communications numériques.

Plus précisément, l'invention concerne la transmission de données mettant en oeuvre un format de modulation de type modulation différentielle. Une telle modulation différentielle permet de transformer une séquence binaire en un signal modulé. La séquence binaire en entrée de l'étape de modulation correspond aux transitions entre les états de la constellation de la modulation utilisée pour générer les symboles modulés. Une modulation différentielle peut donc être vue comme un encodage différentiel d'une séquence binaire, délivrant une autre séquence binaire, suivi d'une modulation classique.

L'invention trouve des applications dans tout système de transmission utilisant une modulation différentielle. Notamment, l'invention trouve des applications dans le domaine des communications optiques :

- à détection directe selon un format de modulation de type DBPSK (en anglais « Differential Binary Phase Shift Keying ») ou DQPSK (en anglais « Differential Quadrature Phase Shift Keying ») à 10Gb/s et 40Gb/s, ou
- à détection cohérente selon un format de modulation de type QPSK (en anglais « Quadrature Phase Keying ») ou PDM-QPSK (en anglais « Polarization Division Multiplexing- QPSK ») à 40Gb/s et 100Gb/s.

**2. Art antérieur**

Dans le domaine des communications optiques, notamment à très haut débit, la modulation de phase présente de nombreux avantages, autant d'un point de vue de l'efficacité spectrale que de la qualité de transmission (par la réduction d'effets non linéaires liés à la modulation d'intensité notamment).

Par exemple, le format de modulation DBPSK est particulièrement avantageux pour des transmissions non cohérentes. En détection directe, la phase du signal transmis est perdue à la réception, mais il est possible de la retrouver en mesurant la différence de phase entre deux symboles successifs, grâce à une démodulation optique réalisée par un interféromètre de type MZDI (en anglais « Mach- Zender Delay Interferometer ») par exemple. L'encodage différentiel des données à transmettre s'avère nécessaire pour pouvoir utiliser une modulation de phase en détection directe.

Les formats de modulation QPSK et PDM-QPSK sont quant à eux particulièrement intéressants pour des transmissions cohérentes présentant un débit supérieur ou égal à 40Gb/s. Grâce à l'utilisation d'un récepteur cohérent, la phase du signal transmis devient directement accessible. On peut donc utiliser des formats de modulation à haute efficacité spectrale. Cependant, le bruit de phase reste un problème majeur, que les algorithmes de récupération de phase (de type Viterbi) n'arrivent pas à traiter totalement. L'encodage différentiel des données à transmettre s'avère là aussi nécessaire.

On constate ainsi que l'encodage différentiel combiné à une modulation de phase permet d'améliorer les performances des systèmes de transmission.

Malheureusement, la mise en oeuvre d'un encodage différentiel conduit à un taux d'erreur plus élevé qu'un encodage classique, car une erreur de transmission produit deux erreurs sur les données transmises sous la forme de symboles d'information. De manière plus générale, $k$ erreurs de transmission successives produisent $k+1$ erreurs sur les symboles d'information...

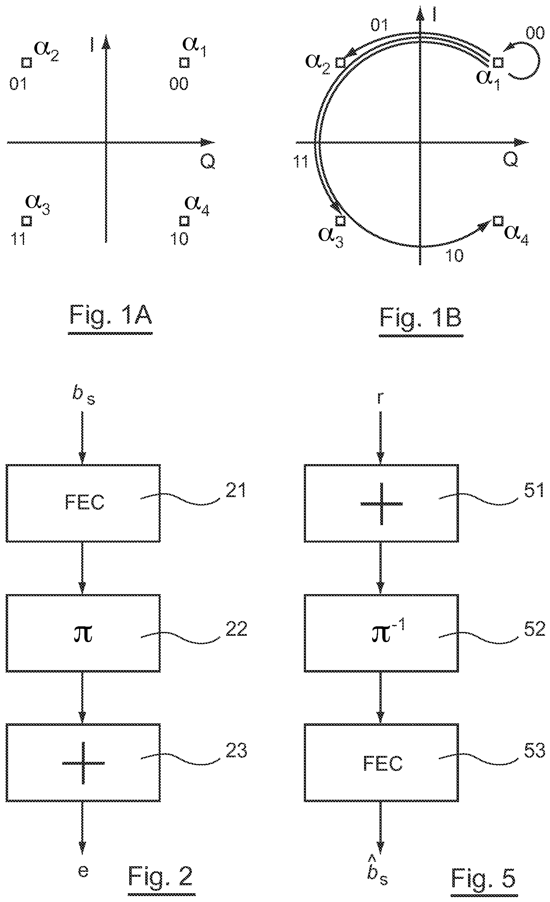

Plus précisément, dans le cas d'une modulation de type QPSK par exemple, l'encodage classique tel qu'illustré en figure 1A permet d'associer un symbole d'information comprenant deux bits, à un symbole modulé, correspondant à un état $\alpha_i$ de la constellation. Pour une modulation QPSK, les états de la constellation associés aux symboles modulés sont : $\alpha_1 = e^{i\pi/4}$, $\alpha_2 = e^{3i\pi/4}$, etc.

L'encodage différentiel tel qu'illustré en figure 1B permet quant à lui de coder les données à transmettre par la transition entre les états de la constellation utilisée. En d'autres termes, un symbole d'information correspond aux deux bits qui encodent le changement de phase entre deux états $\alpha_i$ de la constellation, c'est-à-dire entre deux symboles modulés. Par exemple, la séquence de symboles d'information '10' '11' '00' est transformée en symboles modulés correspondants aux états $\alpha_1$, $\alpha_4$, $\alpha_2$, $\alpha_2$. Si, après passage dans le canal de transmission, les symboles modulés reçus correspondent aux états $\alpha_1$, $\alpha_4$, $\underline{\alpha_1}$, $\alpha_2$, ce qui correspond à une erreur de transmission, alors les symboles d'information reconstruits seront '10' '$\underline{01}$' '$\underline{01}$', ce qui correspond à deux erreurs sur les données transmises (apparaissant en caractère souligné).

L'encodage différentiel conduit donc à des taux d'erreur plus élevés que l'encodage classique, car une erreur de transmission corrompt deux symboles d'information consécutifs.

Il existe donc un besoin pour une nouvelle technique de transmission mettant en oeuvre une modulation différentielle, permettant de reconstruire de manière plus fiable les données transmises. Document US3891959 présente une technique d'encodage différentiel utilisée dans un système mettant en oeuvre une modulation de phase à 4 états.

**3. Exposé de l'invention**

L'invention propose une solution nouvelle qui ne présente pas l'ensemble de ces inconvénients de l'art antérieur, sous la forme d'un procédé de modulation d'une séquence binaire source formée d'une pluralité de mots source, délivrant des symboles modulés.

Selon l'invention, un tel procédé met en oeuvre les étapes suivantes :

- codage correcteur d'erreurs de la pluralité de mots source, mettant en oeuvre un ou plusieurs modules de codage mettant chacun en oeuvre un code correcteur d'erreurs distinct, délivrant une pluralité de mots de code,
  lesdits mots source étant codés successivement ;
- entrelacement des mots de code, délivrant une séquence entrelacée ;
- modulation différentielle de la séquence entrelacée, délivrant des symboles modulés.

Chaque mot de code est décomposé en au moins un groupe présentant un nombre de bits égal au logarithme en base deux du nombre d'états de la modulation mise en oeuvre lors de l'étape de modulation différentielle. L'étape d'entrelacement répartit les groupes dans la séquence entrelacée, de façon que deux groupes adjacents dans la séquence entrelacée appartiennent à des mots de code distincts.

L'invention propose ainsi une nouvelle technique de transmission permettant de reconstruire de manière plus fiable les données transmises, en combinant l'utilisation de techniques de codage correcteur d'erreurs et d'encodage différentiel.

Pour ce faire, l'invention repose sur une décomposition en groupes des mots de code issus de l'étape de codage correcteur d'erreurs et sur un entrelacement particulier de ces mots de code, délivrant une séquence entrelacée dans laquelle deux groupes de bits consécutifs appartiennent à des mots de code distincts. On note qu'il est possible d'entrelacer n'importe quel nombre de mots de code selon l'invention (deux, trois, quatre ou plus), du moment que deux groupes adjacents dans la séquence entrelacée n'appartiennent pas au même mot de code.

De cette façon, quant bien même une erreur de transmission corrompt deux groupes de bits consécutifs, ces groupes appartiennent à des mots de code différents. Les performances de décodage des mots de code ne sont donc que très peu diminuées.

En particulier, chacun des groupes de la séquence entrelacée est représentatif d'une transition entre deux symboles modulés. Ainsi, la taille de ces groupes (i.e. le nombre de bits par groupe) dépend de la modulation mise en oeuvre. Par exemple, pour une modulation BPSK, le nombre de bits par groupe est égal à 1 ; pour une modulation QPSK, le nombre de bits par groupe est égal à 2 ; pour une modulation 8PSK, le nombre de bits pas groupe est égal à 3, etc. Deux groupes adjacents correspondent donc à deux transitions consécutives, correspondant par exemple aux sauts de phase consécutifs entre trois symboles modulés pour une modulation de phase.

Par ailleurs, si le nombre de bits formant un mot de code ne correspond pas à un multiple du nombre de bits par groupe, il est possible d'avoir un groupe particulier présentant un nombre de bits inférieur au logarithme en base deux du nombre d'états de la modulation. Ce groupe particulier peut notamment être complété par des bits égaux à '0' ou '1', pour obtenir une taille égale à celle des autres groupes.

Selon un aspect particulier de l'invention, l'étape de codage correcteur d'erreurs met en oeuvre au moins deux codes correcteur d'erreurs distincts, délivrant chacun des mots de code distincts.

Dans ce cas, l'étape de codage met en oeuvre plusieurs modules de codage mettant chacun en oeuvre un code correcteur d'erreurs distinct.

En particulier, lorsque les mots de code obtenus par la mise en oeuvre de codes correcteurs d'erreurs distincts présentent une longueur différente, l'étape d'entrelacement entrelace les groupes jusqu'à avoir réparti tous les groupes du mot de code présentant la plus petite longueur. Les groupes restants sont alors « recopiés » dans la séquence entrelacée.

Ainsi, deux groupes adjacents dans la séquence modulée appartiennent à des mots de code distincts, jusqu'à avoir utilisé tous les groupes du mot de code le plus court. Ensuite, il est possible que des groupes voisins dans la séquence entrelacée appartiennent à un même mot de code.

Si l'étape d'entrelacement entrelace trois mots de code de longueur distincte, on entrelace ces trois mots de code jusqu'à avoir réparti tous les groupes du mot de code le plus court (parmi ces trois mots de code), puis les deux mots de code restant jusqu'à avoir réparti tous les groupes du mot de code le plus court parmi ces deux mots de code restant. De cette façon, seuls les derniers groupes du mot de code le plus long peuvent éventuellement être voisins dans la séquence entrelacée.

Selon une variante de réalisation, les mots de code comprenant des bits d'information et des bits de redondance, chaque mot de code est décomposé en au moins un groupe de bits d'information et au moins un groupe de bits de redondance. L'étape d'entrelacement répartit alors les groupes de bits d'information dans la séquence entrelacée, de façon que deux groupes de bits d'information adjacents dans la séquence entrelacée appartiennent à des mots de code distincts.

On note que selon cette variante, l'entrelacement assure que des groupes de bits d'information voisins n'appartiennent pas à un même mot de code, alors que des groupes de bits de redondance (ou de parité) voisins peuvent appartenir à un même mot de code.

Cette variante est particulièrement avantageuse lorsque les mots de code obtenus par les différents modules de codage présentent une taille (longueur) différente.

Il est ainsi possible d'utiliser des codes correcteurs d'erreurs présentant des performances différentes, et notamment un premier code correcteur d'erreurs présentant une capacité de correction supérieure à celle d'un deuxième code correcteur d'erreurs.

L'invention concerne également un produit programme d'ordinateur téléchargeable depuis un réseau de communication et/ou enregistré sur un support lisible par ordinateur et/ou exécutable par un processeur comprenant des instructions de code de programme pour la mise en oeuvre du procédé de modulation tel que décrit précédemment.

Le procédé de modulation selon l'invention peut donc être mis en oeuvre de diverses manières, et notamment sous forme câblée ou sous forme logicielle.

Dans un autre mode de réalisation, l'invention concerne un dispositif de modulation d'une séquence binaire source formée d'une pluralité de mots source, délivrant des symboles modulés, comprenant :

- des moyens de codage correcteur d'erreurs de la pluralité de mots source, mettant en oeuvre un ou plusieurs modules de codage mettant chacun en oeuvre un code correcteur d'erreurs distinct, délivrant une pluralité de mots de code, lesdits mots source étant codés successivement ;
- des moyens d'entrelacement des mots de code, délivrant une séquence entrelacée ;
- des moyens de modulation différentielle de la séquence entrelacée, délivrant des symboles modulés.

Selon l'invention, chaque mot de code est décomposé en au moins un groupe présentant un nombre de bits égal au logarithme en base deux d'un nombre d'états d'une modulation différentielle mise en oeuvre par les moyens de modulation différentielle, et les moyens d'entrelacement répartissent les groupes dans la séquence entrelacée, de façon que deux groupes adjacents dans la séquence entrelacée appartiennent à des mots de code distincts.

Un tel dispositif de modulation est notamment adapté à mettre en oeuvre le procédé de modulation décrit précédemment. Il peut notamment être intégré à un émetteur utilisé pour les communications optiques.

Ce dispositif de modulation pourra bien sûr comporter les différentes caractéristiques relatives au procédé de modulation selon l'invention. Ainsi, les caractéristiques et avantages de ce dispositif sont les mêmes que ceux du procédé de modulation, et ne sont pas détaillés plus amplement.

L'invention concerne aussi un signal comprenant des symboles modulés obtenus à partir d'une séquence binaire source formée d'une pluralité de mots source ayant subi avant émission :

- un codage correcteur d'erreurs de la pluralité de mots source, mettant en oeuvre un ou plusieurs modules de codage mettant chacun en oeuvre un code correcteur d'erreurs distinct, délivrant une pluralité de mots de code ; lesdits mots source étant codés successivement ;
- un entrelacement des mots de code, délivrant une séquence entrelacée ;

- une modulation différentielle de la séquence entrelacée, délivrant des symboles modulés ;

chaque mot de code étant décomposé en au moins un groupe présentant un nombre de bits égal au logarithme en base deux d'un nombre d'états de ladite modulation différentielle, et l'entrelacement répartissant les groupes dans la séquence entrelacée, de façon que deux groupes adjacents dans la séquence entrelacée appartiennent à des mots de code distincts.

Un tel signal peut notamment être formé de symboles modulés obtenus selon le procédé de modulation décrit ci-dessus. Ce signal pourra bien sûr comporter les différentes caractéristiques relatives au procédé de modulation selon l'invention.

Dans un autre mode de réalisation, l'invention concerne un procédé de démodulation de symboles reçus, correspondant à des symboles modulés selon le procédé de modulation décrit précédemment après passage dans un canal de transmission, délivrant une séquence binaire reconstruite.

Selon l'invention, un tel procédé met en oeuvre les étapes suivantes :

- démodulation différentielle des symboles reçus, mettant en oeuvre un traitement inverse à la modulation différentielle mise en oeuvre en émission, délivrant une séquence démodulée ;
- désentrelacement de la séquence démodulée, mettant en oeuvre un traitement inverse à l'entrelacement mis en oeuvre en émission, délivrant une pluralité de mots de code ;
- décodage des mots de code, délivrant la séquence binaire reconstruite.

Un tel procédé de démodulation est notamment adapté à démoduler un signal modulé selon le procédé de modulation décrit précédemment. Ainsi, la séquence démodulée obtenue en sortie de l'étape de modulation différentielle correspond à la séquence entrelacée obtenue côté modulation, éventuellement affectée par des erreurs de transmission, et peut être décomposée en groupes de bits tels que deux groupes consécutifs appartiennent à des mots de code distincts.

En particulier, l'étape de décodage met en oeuvre les étapes suivantes :

  ○ correction, à partir d'au moins un code correcteur d'erreurs, d'au moins un premier mot de code comprenant au moins un groupe comprenant au moins un bit erroné, dit groupe courant, délivrant un premier mot de code corrigé ;
  ○ correction, à partir du premier mot de code corrigé, d'au moins un mot de code distinct comprenant un groupe adjacent au groupe courant dans la séquence démodulée, dit groupe voisin.

De cette façon, il est possible de décoder de manière classique certains mots de code, en utilisant le ou les codes correcteurs d'erreurs mis en oeuvre en émission (en utilisant un décodage algébrique pour des codes correcteurs d'erreurs de type BCH ou Reed Solomon par exemple, ou d'autres techniques de décodage pour des codes correcteurs d'erreurs de type LDPC par exemple), et d'en déduire le décodage d'autres mots de code.

Plus précisément, si l'on détecte une erreur affectant un groupe courant, le groupe adjacent précédant ou suivant le groupe courant dans la séquence démodulée est nécessairement lui aussi affecté par des erreurs, puisque lorsqu'un encodage différentiel est utilisé, une erreur de transmission corrompt deux groupes de bits consécutifs.

Or on rappelle que deux groupes consécutifs dans la séquence démodulée appartiennent nécessairement à des mots de code distincts, grâce à l'entrelacement spécifique utilisé côté modulation. Il est donc possible de localiser, puis de corriger, les erreurs affectant un mot de code distinct, une fois que l'on a détecté et corrigé une erreur affectant un groupe courant d'un premier mot de code.

Selon une première variante de réalisation, le procédé de démodulation comprend une étape d'affectation d'une première valeur de confiance au symbole reçu obtenu à partir du groupe voisin précédent le groupe courant dans la séquence démodulée (c'est-à-dire au symbole reçu à l'origine de la transition encodée par le groupe courant), et d'une deuxième valeur de confiance au symbole reçu obtenu à partir du groupe courant (c'est-à-dire au symbole reçu destinataire de la transition encodée par le groupe courant).

En d'autres termes, on caractérise :

- la confiance accordée au groupe voisin précédent, à partir du symbole reçu modulé à l'origine de la transition encodée par le groupe courant, et
- la confiance accordée au groupe voisin suivant, à partir du symbole reçu modulé destinataire de (ou suivant) la transition encodée par le groupe courant.

L'étape de correction du mot de code distinct est alors mise en oeuvre pour le groupe voisin précédant le groupe courant dans la séquence démodulée et/ou pour le groupe voisin suivant le groupe courant dans la séquence démodulée en tenant compte de ces valeurs de confiance.

En particulier, les valeurs de confiance sont égales au logarithme du rapport de vraisemblance (LLR) associé au symbole reçu correspondant.

Ces valeurs de confiance permettent ainsi de décider si c'est le groupe voisin précédent, le groupe voisin suivant, ou les deux groupes voisins qui est (ou sont) probablement erronés, et donc de réduire le nombre de mots de code « candidats » associés à un mot de code. On augmente ainsi la rapidité de l'algorithme de décodage.

En particulier, la décision de corriger le groupe voisin précédent et/ou le groupe voisin suivant peut dépendre d'un seuil *s*, permettant de définir si les deux symboles reçus sont équivalemment fiables ou pas. Si le seuil est égal à 100%, cela signifie que les deux symboles reçus sont équivalemment fiable, et il faut corriger chacun des groupes voisins. Dans ce cas, puisqu'on cherche à corriger à la fois le groupe voisin précédent et le groupe voisin suivant, il n'est pas nécessaire de déterminer ces valeurs de confiance.

Selon une deuxième variante, l'étape de correction du mot de code distinct comprend :

- une étape de détermination d'au moins un mot de code candidat pour le mot de code distinct ;
- une étape de détermination du syndrome associé au(x) mot(s) de code candidats ;
- une étape de sélection du mot de code candidat présentant un syndrome nul, délivrant le mot de code distinct corrigé.

Ces étapes permettent notamment de déterminer si une erreur affecte le groupe voisin précédent, le groupe voisin suivant, ou les deux groupes voisins. Elle permet aussi de réduire le nombre de mots de code candidats associés à un mot de code, puisqu'elles permettent de conserver uniquement les mots de code candidats présentant un syndrome nul. On augmente donc la rapidité de l'algorithme de décodage.

La première et la deuxième variantes peuvent aussi être combinées.

L'invention concerne aussi un produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé de démodulation tel que décrit ci-dessus.

Le procédé de démodulation selon l'invention peut donc être mis en oeuvre de diverses manières, et notamment sous forme câblée ou sous forme logicielle.

Dans un autre mode de réalisation, l'invention concerne un dispositif de démodulation de symboles reçus, correspondant à des symboles modulés après passage dans un canal de transmission, délivrant une séquence binaire reconstruite, les symboles modulés étant obtenus à partir d'une séquence binaire source, ayant subi avant émission :

- un codage correcteur d'erreurs de la séquence binaire source, délivrant une pluralité de mots de code ;
- un entrelacement des mots de code, délivrant une séquence entrelacée ;
- une modulation différentielle de la séquence entrelacée, délivrant des symboles modulés ;

chaque mot de code étant décomposé en au moins un groupe présentant un nombre de bits égal au logarithme en base deux du nombre d'états de la modulation différentielle, et l'entrelacement répartissant les groupes dans la séquence entrelacée de façon que deux groupes adjacents dans la séquence entrelacée appartiennent à des mots de code distincts.

Selon l'invention, un tel dispositif comprend :

- des moyens de démodulation différentielle des symboles reçus, mettant en oeuvre un traitement inverse à la modulation différentielle mise en oeuvre en émission, délivrant une séquence démodulée ;
- des moyens de désentrelacement de la séquence démodulée, mettant en oeuvre un traitement inverse à l'entrelacement mis en oeuvre en émission, délivrant une pluralité de mots de code ;
- des moyens de décodage des mots de code, délivrant la séquence binaire reconstruite.

Un tel dispositif est notamment adapté à mettre en oeuvre le procédé de démodulation décrit précédemment, et à recevoir des symboles modulés selon le procédé de modulation décrit précédemment. Il peut notamment être intégré à un récepteur utilisé pour les communications optiques.

Ce dispositif de démodulation pourra bien sûr comporter les différentes caractéristiques relatives au procédé de démodulation selon l'invention. Ainsi, les caractéristiques et avantages de ce dispositif sont les mêmes que ceux du procédé de démodulation, et ne sont pas détaillés plus amplement.

## 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :

- les figures 1A et 1B rappellent le fonctionnement d'une modulation classique et d'une modulation différentielle ;
- la figure 2 illustre les principales étapes mises en oeuvre par le procédé de modulation selon un mode de réalisation particulier de l'invention ;
- les figures 3A à 3C présentent trois exemples de mise en oeuvre du procédé de modulation selon la figure 2 ;
- la figure 4 illustre les performances de l'invention, par rapport aux techniques de l'art antérieur ;
- la figure 5 illustre les principales étapes mises en oeuvre par le procédé de démodulation selon un mode de réalisation de l'invention ;
- la figure 6 présente un exemple de mise en oeuvre du procédé de démodulation selon la figure 5 ;
- les figures 7A et 7B représentent la complexité de l'algorithme de décodage, en fonction du nombre de syndromes calculés et du nombre de décodages réalisés, en moyenne, pour un second mot de code ;
- les figures 8A et 8B illustrent les structures simplifiées d'un dispositif de modulation et d'un dispositif de démodulation selon un mode de réalisation particulier de l'invention.

## 5. Description d'un mode de réalisation de l'invention

### 5.1 Principe général

Le principe général de l'invention repose sur un regroupement spécifique des bits composant un mot de code, et un entrelacement spécifique de ces groupes, permettant de répartir les groupes des différents mots de code dans une séquence entrelacée, de façon que deux groupes adjacents (i.e. côte à côte dans la séquence entrelacée) appartiennent à des mots de code distincts. On note que ces groupes adjacents correspondent à des transitions consécutives, correspondant par exemple aux sauts de phase consécutifs entre les symboles modulés pour une modulation de phase.

En d'autres termes, l'invention propose de répartir les erreurs survenant au cours de la transmission sur des mots de code différents. On entrelace donc les mots de code issus du codage correcteur d'erreurs de manière à ne pas avoir deux groupes de bits provenant d'un même mot de code côte à côte. Si une erreur de transmission se produit, elle corrompt ainsi deux groupes de bits côte à côte, qui appartiennent à des mots de code différents, et qui sont décodés par un même décodeur s'ils sont issus d'un même code correcteur d'erreurs (ou FEC, en anglais « Forward Error Correction »), et par des décodeurs différents s'ils sont issus de codes correcteurs d'erreurs (FEC) différents.

L'invention permet ainsi d'améliorer les performances de transmission en répartissant les erreurs de transmission entre plusieurs mots de code, grâce à une combinaison des techniques de codage correcteur d'erreurs, de modulation utilisant un encodage différentiel, et d'un entrelacement spécifique. On adapte ainsi les techniques de codage correcteur d'erreurs aux particularités de l'encodage différentiel.

La figure 2 illustre les principales étapes mises en oeuvre côté modulation, pour la modulation d'une séquence binaire source $b_s$ formée d'une succession de mots source, délivrant des symboles modulés $e$, associés chacun à un état $\alpha_i$ d'une constellation correspondante. Ces symboles modulés peuvent ensuite être transmis via une communication optique par exemple, sous la forme d'un signal modulé.

Un tel procédé de modulation met tout d'abord en oeuvre une étape de codage correcteur d'erreurs 21 de la séquence binaire source $b_s$, encore notée FEC, délivrant une pluralité de mots de code.

Cette étape de codage correcteur d'erreurs 21 permet d'encoder les mots source de la séquence binaire source $b_s$, formés de bits d'information, en utilisant au moins un code correcteur d'erreurs. On obtient ainsi des mots de code en sortie de cette étape 21, qui comprennent à la fois des bits d'information et des bits de redondance.

L'étape de codage correcteur d'erreurs 21 peut mettre en oeuvre un ou plusieurs modules de codage FEC, mettant chacun en oeuvre un code correcteur d'erreurs distinct délivrant un mot ou plusieurs mots de code. On note que le nombre de modules de codage FEC ne dépend pas du nombre d'états de la modulation différentielle (ou de la constellation).

Au cours d'une étape suivante d'entrelacement 22, les mots de code (deux, trois, quatre, ou plus) sont entrelacés, délivrant une séquence entrelacée.

Plus précisément, les mots de code peuvent être décomposés en groupes présentant un nombre de bits égal au logarithme en base deux du nombre d'états de la modulation différentielle. On rappelle que si le nombre de bits formant un mot de code ne correspond pas à un multiple du nombre de bits par groupe, il est aussi possible d'avoir un groupe particulier présentant un nombre de bits inférieur au logarithme en base deux du nombre d'états de la modulation.

L'étape d'entrelacement 22 répartit alors les différents groupes de façon que deux groupes adjacents dans la séquence entrelacée appartiennent à des mots de code distincts. Par exemple, si l'on considère deux mots de code distincts, la séquence entrelacée est composée d'un premier groupe de bits du premier mot de code, suivi d'un premier groupe de bits du deuxième mot de code, suivi d'un deuxième groupe de bits du premier mot de code, suivi d'un deuxième groupe de bits du deuxième mot de code, etc. On peut ainsi considérer que les groupes associés à différents mots de code sont placés les uns à la suite des autres dans la séquence entrelacée, en alternant les groupes appartenant à des mots de code différents.

On note que cette étape d'entrelacement 22 dépend du nombre d'états de la modulation différentielle. En d'autres termes, on entrelace des paquets (groupes) de plusieurs bits, dont la taille varie en fonction de la constellation associée à la modulation différentielle. Par exemple, on entrelace les bits deux par deux dans le cas d'une modulation QPSK.

Finalement, au cours d'une étape de modulation différentielle 23, la séquence entrelacée de groupes de bits est modulée, délivrant des symboles modulés $e$, associés chacun à un état $\alpha_i$ de la constellation. On constate ainsi que chaque symbole modulé est construit à partir d'un groupe de bits provenant d'un même mot de code.

On rappelle que la séquence entrelacée en entrée de l'étape de modulation différentielle correspond aux transitions entre les symboles modulés. Chaque groupe de la séquence entrelacée est donc représentatif d'une transition entre deux symboles modulés. Ainsi, les mots de code entrelacés représentent les transitions entre les symboles modulés émis.

*5.2 Exemples de mise en oeuvre de la technique de modulation*

On décrit ci-après quelques exemples de mise en oeuvre de l'invention pour différents formats de modulation, pour lesquels le nombre de bits par groupe est supérieur ou égal à deux.

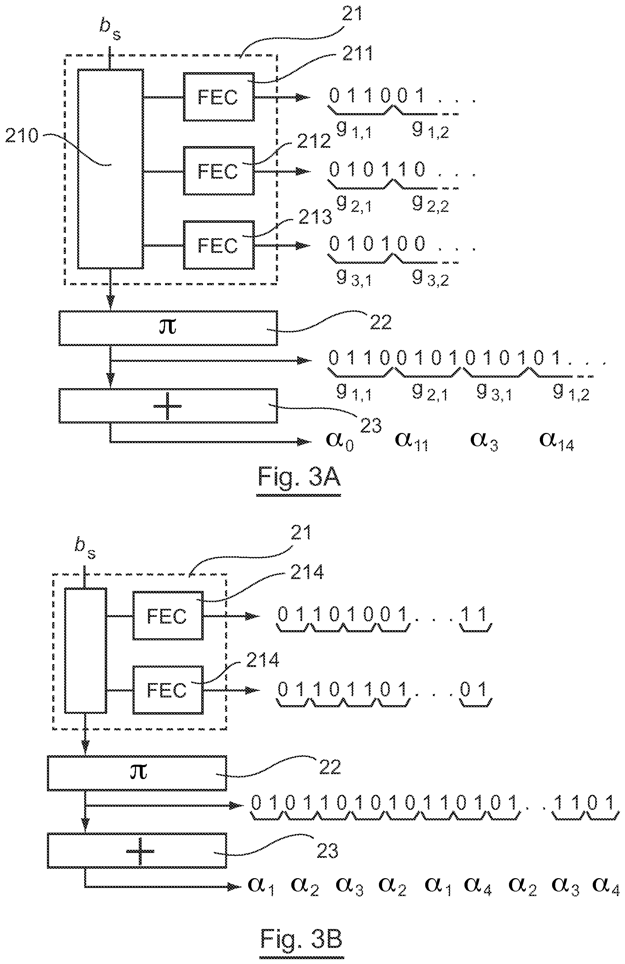

Plus précisément, la figure 3A illustre les principales étapes mises en oeuvre pour une modulation d'amplitude à 16 états (modulation 16QAM).

Comme indiqué précédemment, les mots source de la séquence binaire $b_s$ sont successivement codés au cours de l'étape de codage correcteur d'erreurs 21. On considère par exemple que cette étape de codage met en oeuvre trois modules de codage FEC 211, 212, 123, mettant chacun en oeuvre un code correcteur distinct délivrant des mots de code présentant une taille identique.

Par exemple, le premier module de codage FEC 211 délivre un premier mot de code '011001...', puis le deuxième module de codage FEC 212 délivre un deuxième mot de code '010110...', puis le troisième module de codage FEC 213 délivre un troisième mot de code '010100...'. En d'autres termes, un seul module de codage FEC est utilisé à un instant donné. Le bloc 210 peut donc être vu comme un sélecteur du module de codage FEC à utiliser pour coder un mot source.

On rappelle que le nombre de modules de codage FEC ne dépend pas du nombre d'états de la modulation différentielle, et que les mots de code issus des différents modules de codage peuvent être de taille différente.

Ces mots de code sont alors entrelacés au cours d'une étape d'entrelacement 22.

Plus précisément, on rappelle que selon l'invention, les mots de code peuvent être décomposés en groupes présentant un nombre de bits égal au logarithme en base deux d'un nombre d'états de la modulation différentielle, soit en groupes de 4 bits pour une modulation 16QAM. La taille d'un groupe, également appelé symbole (d'information ou de redondance), dépend donc de la constellation.

On définit ainsi un premier groupe dans le premier mot de code, noté $g_{1,1}$, comprenant les bits '0110', un deuxième groupe dans le premier mot de code, noté $g_{1,2}$, comprenant les bits '01..', un premier groupe dans le deuxième mot de code, noté $g_{2,1}$, comprenant les bits '0101', un deuxième groupe dans le deuxième mot de code, noté $g_{2,2}$, comprenant les bits '10..', un premier groupe dans le troisième mot de code, noté $g_{3,1}$, comprenant les bits '0101', un deuxième groupe dans le troisième mot de code, noté $g_{3,2}$, comprenant les bits '00..', etc.

Ces groupes sont alors entrelacés, de façon que deux groupes adjacents n'appartiennent pas au même mot de code.

Par exemple, la séquence entrelacée comprend les groupes successifs suivants : $g_{1,1}$, $g_{2,1}$, $g_{3,1}$,

$g_{1,2}$, etc. Selon une variante, la séquence entrelacée comprend les groupes successifs suivants: $g_{1,1}$, $g_{3,1}$, $g_{2,1}$, $g_{1,2}$, etc. Selon une autre variante, la séquence entrelacée comprend les groupes successifs suivants : $g_{2,1}$, $g_{1,1}$, $g_{3,1}$, $g_{2,2}$, etc. L'essentiel est que deux groupes consécutifs dans la séquence entrelacée n'appartiennent pas à un même mot de code.

On note que l'entrelacement de groupes appartenant à trois mots de code différents permet d'améliorer certaines performances. On rappelle en effet que deux erreurs de transmission produisent en général trois groupes (ou symboles d'information ou de redondance) erronés. Ainsi, en utilisant trois mots de code, deux erreurs de transmission successives peuvent être mieux corrigées. En effet, ces trois groupes sont, selon l'invention, répartis sur trois mots de code différents. On note qu'avec un entrelacement de deux mots de code seulement et deux erreurs de transmission, un des mots de code aurait eu un seul groupe de bits erroné, et l'autre mot de code aurait eu deux groupes de bits erronés. Il est donc possible, selon l'invention, d'utiliser un entrelacement sur plus de deux mots de code.

La séquence entrelacée ainsi obtenue est alors modulée au cours de l'étape de modulation différentielle 23, délivrant les symboles modulés associés par exemple aux points $\alpha_0$ $\alpha_{11}$ $\alpha_3$ $\alpha_{14}$ de la constellation. C'est au cours de cette étape de modulation différentielle 23 que l'on réalise les opérations classiques de conversion série/parallèle de la séquence entrelacée, et de répartition sur une voie en phase et une voie en quadrature.

On présente ci-après, en relation avec la figure 3B, les principales étapes mises en oeuvre pour une modulation de phase à 4 états (modulation QPSK).

Comme indiqué précédemment, plusieurs mots de code sont délivrés au cours de l'étape de codage correcteur d'erreurs 21. On considère par exemple que cette étape de codage met en oeuvre un unique module de codage FEC 214, délivrant au moins deux mots de code. Selon l'exemple illustré en figure 3B, ce module de codage FEC 214 code tout d'abord un premier mot source de la séquence binaire $b_s$, et délivre un premier mot de code comprenant des bits d'information '01101001...' et des bits de redondance '11'. Le module de codage FEC 214 code ensuite un deuxième mot source de la séquence binaire $b_s$, et délivre un deuxième mot de code comprenant des bits d'information '01101101...' et des bits de redondance '01'.

Ces mots de code sont alors entrelacés au cours d'une étape d'entrelacement 22.

Pour ce faire, les mots de code provenant de l'unique module de codage FEC 214 sont tous les deux mis en mémoire. Les mots de code sont alors décomposés en groupes présentant un nombre de bits égal au logarithme en base deux d'un nombre d'états de la modulation différentielle, soit en groupes de deux bits pour une modulation QPSK.

Le premier mot de code comprend ainsi les groupes '01', '10', '10', '01',...(comprenant des bits d'information), et '11' (comprenant des bits de redondance). Le deuxième mot de code comprend les groupes '01', '10', '11', '01', ...(comprenant des bits d'information), et '01' (comprenant des bits de redondance). Ces groupes sont alors entrelacés, de façon que deux groupes adjacents n'appartiennent pas au même mot de code.

Par exemple, la séquence entrelacée comprend les groupes successifs suivants : '01', '01', '10', '10', '10', '11', '01', '01', ..., '11', '01'.

Il est ainsi possible d'utiliser un seul module de codage, si l'on souhaite obtenir plusieurs mots de code en utilisant un même code correcteur d'erreurs.

La séquence entrelacée ainsi obtenue est alors modulée au cours de l'étape de modulation différentielle 23, délivrant les symboles modulés associés aux points $\alpha_1$ $\alpha_2$ $\alpha_3$ $\alpha_2$ $\alpha_1$ $\alpha_4$ $\alpha_2$ $\alpha_3$ $\alpha_4$ de la constellation.

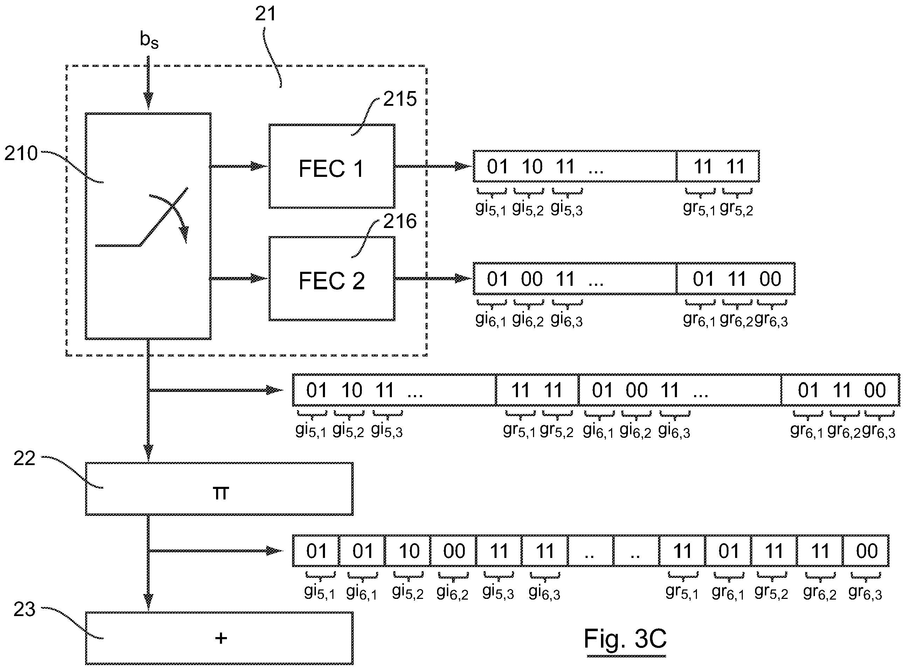

On présente désormais, en relation avec la figure 3C, une variante de réalisation selon laquelle l'étape de codage correcteur d'erreurs 21 met en oeuvre deux modules de codage FEC1 215 et FEC2 216, mettant chacun en oeuvre un code correcteur distinct générant des mots de code de longueur distincte.

Selon un premier exemple, le premier module de codage FEC1 215 met en oeuvre un code BCH(1022, 842) et le deuxième module de codage FEC2 216 met en oeuvre un code BCH(942, 842). Selon cet exemple, les mots de code issus des modules de codage FEC1 215 et FEC2 216 présentent donc une longueur différente, mais un même nombre de bits d'information.

Selon cet exemple, et comme décrit précédemment, les mots source de la séquence binaire $b_s$ sont successivement codés au cours de l'étape de codage correcteur d'erreurs 21. Par exemple, le premier module de codage FEC1 215 délivre un premier mot de code comprenant les bits d'information '011011...' et les bits de redondance '1111', puis le deuxième module de codage FEC2 216 délivre un deuxième mot de code comprenant les bits d'information '010011...' et les bits de redondance '011100'.

Ces mots de code sont, selon cette variante, décomposés en groupes de bits d'information et en groupes de bits de redondance. Par exemple, si on considère de nouveau une modulation QPSK, les mots de code sont décomposés en groupes de bits d'information et en groupes de bits de redondance de deux bits.

On définit ainsi, dans le premier mot de code :

- un premier groupe de bits d'information, noté $gi_{5,1}$, comprenant les bits '01' ;
- un deuxième groupe de bits d'information, noté $gi_{5,2}$, comprenant les bits '10' ;
- un troisième groupe de bits d'information, noté $gi_{5,3}$, comprenant les bits '11' ;
- etc ;
- un premier groupe de bits de redondance, noté $gr_{5,1}$, comprenant les bits '11' ;
- un deuxième groupe de bits de redondance, noté $gr_{5,2}$, comprenant les bits '11'.

et dans le deuxième mot de code :

- un premier groupe de bits d'information, noté $gi_{6,1}$, comprenant les bits '01' ;
- un deuxième groupe de bits d'information, noté $gi_{6,2}$, comprenant les bits '00' ;
- un troisième groupe de bits d'information, noté $gi_{6,3}$, comprenant les bits '11' ;
- etc ;
- un premier groupe de bits de redondance, noté $gr_{6,1}$, comprenant les bits '01' ;
- un deuxième groupe de bits de redondance, noté $gr_{6,2}$, comprenant les bits '11' ;
- un troisième groupe de bits de redondance, noté $gr_{6,3}$, comprenant les bits '00'.

A l'issue de l'étape de codage 21, on obtient donc une séquence codée formée des deux mots de code issus des codeurs FEC1 215 et FEC2 216.

Selon cette variante de réalisation, les groupes sont alors entrelacés au cours de l'étape 22 d'entrelacement, de façon que deux groupes de bits d'information adjacents n'appartiennent pas au même mot de code. Les groupes de bits de redondance peuvent également être entrelacés.

La séquence entrelacée ainsi obtenue comprend, par exemple, les groupes successifs suivants : $gi_{5,1}$, $gi_{6,1}$, $gi_{5,2}$, $gi_{6,2}$, $gi_{5,3}$, $gi_{6,3}$, ..., $gr_{5,1}$, $gr_{6,1}$, $gr_{5,2}$, $gr_{6,2}$, $gr_{6,3}$.

L'étape d'entrelacement assure donc que les groupes de bits d'information voisins n'appartiennent pas à un même mot de code, alors que des groupes de bits de redondance (ou de parité) voisins peuvent appartenir à un même mot de code.

Selon ce premier exemple, comme le deuxième codeur FEC2 216 délivre des mots de code présentant une longueur supérieure à celle des mots de code délivrés par le premier codeur FEC1 215, plusieurs groupes de bits de redondance appartenant au deuxième mot de code se suivent dans la séquence entrelacée ($gr_{6,2}$, $gr_{6,3}$).

La séquence entrelacée ainsi obtenue est alors modulée au cours de l'étape de modulation différentielle 23.

Selon un deuxième exemple, le premier module de codage FEC1 215 met en oeuvre un code BCH(1022, 982) et le deuxième module de codage FEC2 216 met en oeuvre un code BCH(942, 862). Selon cet exemple, les mots de code issus des modules de codage FEC1 215 et FEC2 216 présentent donc une longueur différente, et un nombre de bits d'information différent.

Dans ce cas, l'entrelacement assure que les groupes voisins dans la séquence entrelacée n'appartiennent pas à un même mot de code, jusqu'à avoir utilisé tous les groupes du mot de code le plus court. Les groupes restants du mot de code le plus long sont alors « recopiés » dans la séquence entrelacée, et peuvent donc se retrouver voisins dans la séquence entrelacée.

Selon ce deuxième exemple, si l'on obtient, à l'issue de l'étape de codage 21, un premier mot de code formé des groupes $gi_{5,1}$, $gi_{5,2}$, ..., $gi_{5,N}$, $gr_{5,1}$, $gr_{5,2}$ et un deuxième mot de code formé des groupes $gi_{6,1}$, $gi_{6,2}$, ..., $gi_{6,N}$, $gi_{6,N+1}$, $gi_{6,N+2}$, $gr_{6,1}$, $gr_{6,2}$, $gr_{6,3}$, la séquence entrelacée obtenue à l'issue de l'étape d'entrelacement 22 comprend les groupes successifs suivants :

$gi_{5,1}$, $gi_{6,1}$, $gi_{5,2}$, $gi_{6,2}$, ..., $gi_{5,N}$, $gi_{6,N}$, $gr_{5,1}$, $gi_{6,N+1}$, $gr_{5,2}$, $gi_{6,N+2}$, ..., $gr_{6,1}$, $gr_{6,2}$, $gr_{6,3}$

Jusqu'à avoir épuisé tous les groupes du mot de code le plus court (premier mot de code), les groupes successifs de la séquence entrelacée appartiennent donc à des mots de code différents ; ensuite (c'est-à-dire à partir du groupe $gi_{6,N+2}$) les groupes successifs de la séquence entrelacée peuvent appartiennent à un même mot de code (deuxième mot de code). On remarque que ces derniers groupes peuvent comprendre uniquement des bits de redondance, ou bien des bits d'information et des bits de redondance.

Dans le cas d'une modulation à deux états, comme la modulation DBPSK, la taille d'un groupe est égale à un bit, ce qui revient à faire un entrelacement bit par bit. Afin de corriger plus facilement les erreurs de transmission, il est toujours nécessaire selon l'invention d'appliquer une loi d'entrelacement spécifique, permettant de répartir les bits de façon que deux bits consécutifs n'appartiennent pas à un même mot de code. L'utilisation d'un entrelacement bit par bit classique n'est en revanche pas optimal pour réduire les défauts de l'encodage différentiel, puisqu'il ne permet pas nécessairement de répartir les erreurs sur des mots de code différents.

Finalement, on constate qu'un codage correcteur d'erreurs $C(n,k,t)$, qui délivre des mots de code de taille $n$ à partir de $k$ bits d'informations et qui corrige jusqu'à $t$ erreurs de transmission, combiné à un entrelacement spécifique et un encodage différentiel selon l'invention, présente les mêmes performances en termes de taux de correction d'erreurs qu'un codage correcteur d'erreurs $C(2n,2k,2t)$ sans entrelacement. L'entrelacement offre donc bien un gain de codage, et ce quel que soit le type de modulation utilisé.

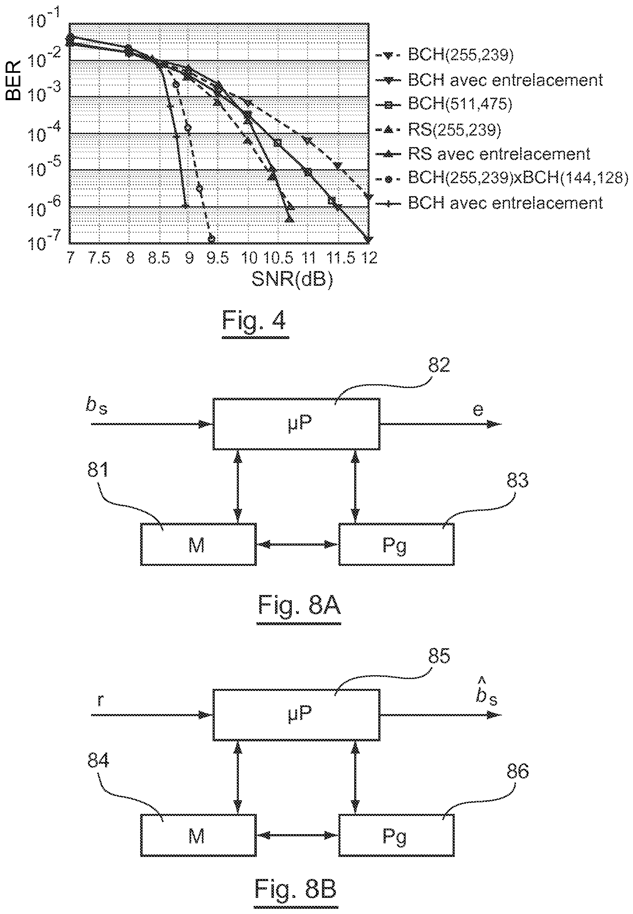

La figure 4 illustre ainsi les performances de l'invention pour une modulation de type QPSK, en comparant le taux d'erreur binaire (BER, en anglais « Binary Error Rate ») en fonction du rapport signal à bruit en dB (SNR, en anglais « Signal to Noise Ratio »), pour différents types de codage correcteur d'erreurs, combinés à un entrelacement spécifique selon l'invention, ou sans entrelacement selon l'art antérieur.

On constate que les performances sont notables lorsque l'étape de codage correcteur d'erreurs met en oeuvre un code correcteur d'erreurs binaire comme le BCH(255,239) ou le code produit BCH(255,239)xBCH(144,128) (avec décodage à décision ferme). Lorsque l'étape de codage correcteur d'erreurs met en oeuvre un code correcteur d'erreurs non binaire comme les Reed-Solomon (RS), la taille du mot de code influe sur les bénéfices de l'entrelacement.

Bien entendu, il est possible d'étendre cette technique à un nombre supérieur de mots de code, et à différentes tailles de constellation modulée en différentiel.

*5.3 Fonctionnement de la technique de démodulation*

La figure 5 illustre les principales étapes mises en oeuvre côté démodulation, pour la démodulation de symboles reçus r correspondant à des symboles modulés *e* après passage dans un canal de transmission, délivrant une séquence binaire reconstruite $\hat{b}_s$.

Ces symboles reçus r peuvent être perturbés par le canal de transmission, ou le récepteur lui même (bruit blanc gaussien additif, distorsion, bruit de phase, interférences, etc). On estime alors le point $\alpha_i$ le plus proche de la constellation qui correspond au symbole reçu. Une erreur apparaît si les perturbations font que le symbole reçu se rapproche d'un point de la constellation qui diffère du point correspondant au symbole modulé émis.

Un tel procédé de démodulation est notamment adapté à recevoir un signal formé de symboles modulés issus du procédé de modulation décrit précédemment.

Plus précisément, un tel procédé met tout d'abord en oeuvre une étape de démodulation différentielle 51 des symboles reçus, mettant en oeuvre un traitement inverse à la modulation différentielle 23 mise en oeuvre en émission, délivrant une séquence démodulée. Si on considère une modulation de phase mise en oeuvre en émission par exemple, il est possible de mesurer le saut de phase entre chaque symbole reçu en réception, et de retrouver les transitions et les groupes de bits encodant ces transitions.

La séquence démodulée est donc formée de groupes de bits successifs, puisque l'on code lors de la modulation différentielle chaque transition par un groupe de bits. Grâce à l'entrelacement spécifique mis en oeuvre en émission, deux groupes de bits successifs appartiennent à des mots de code différents.

La séquence démodulée est ensuite désentrelacée au cours d'une étape de désentrelacement 52, mettant en oeuvre un traitement inverse à l'entrelacement 22 mis en oeuvre en émission, délivrant une pluralité de mots de code.

Les mots de code obtenus sont alors décodés au cours d'une étape de décodage 53, délivrant la séquence binaire reconstruite $\hat{b}_s$.

Sachant que la séquence démodulée présente une structure spécifique, selon laquelle deux groupes consécutifs n'appartiennent pas à un même mot de code, il est possible de réduire la complexité de décodage.

En effet, il est possible selon l'invention de décoder classiquement certains mots de code, et d'utiliser ces mots de code corrigés pour décoder d'autres mots de code.

Par décodage classique, on entend un décodage algébrique pour des codes correcteurs d'erreurs de type BCH ou Reed Solomon par exemple, ou d'autres techniques de décodage classiques pour des codes correcteurs d'erreurs de type LDPC par exemple.

Ainsi, l'étape de décodage 53 met par exemple en oeuvre une correction d'au moins un mot de code en utilisant un décodage correspondant au codage utilisé en émission, délivrant un mot de code corrigé, et une correction d'au moins un mot de code distinct à partir du mot de code corrigé précédemment.

En effet, on rappelle que les erreurs se produisent toujours au moins par paires dans le cadre d'un encodage différentiel. Ainsi, si on localise une erreur dans un groupe de bits d'un premier mot de code en utilisant un algorithme classique de détection/correction d'erreurs, appelé par la suite groupe courant, alors le groupe adjacent précédant ou suivant le groupe courant dans la séquence démodulée, dit groupe voisin, est nécessairement lui aussi affecté par des erreurs. De plus, de part la fonction spécifique d'entrelacement mise en oeuvre selon l'invention, on est assuré que les deux groupes affectés par des erreurs (groupe courant et groupe voisin) appartiennent à des mots de code distincts. Enfin, la connaissance de la valeur de l'erreur sur le groupe courant permet de déduire la valeur de l'erreur sur le groupe voisin.

On peut ainsi localiser et corriger les erreurs affectant un deuxième mot de code, connaissant les erreurs affectant un premier mot de code.

Ainsi, si l'on considère que la séquence démodulée comprend deux mots de code entrelacés, on peut ne décoder de manière classique qu'un mot de code sur les deux, et en déduire la correction à effectuer sur le second. Il est ainsi possible de réduire la complexité de décodage par deux.

*5.4 Exemple de mise en oeuvre de la technique de démodulation*

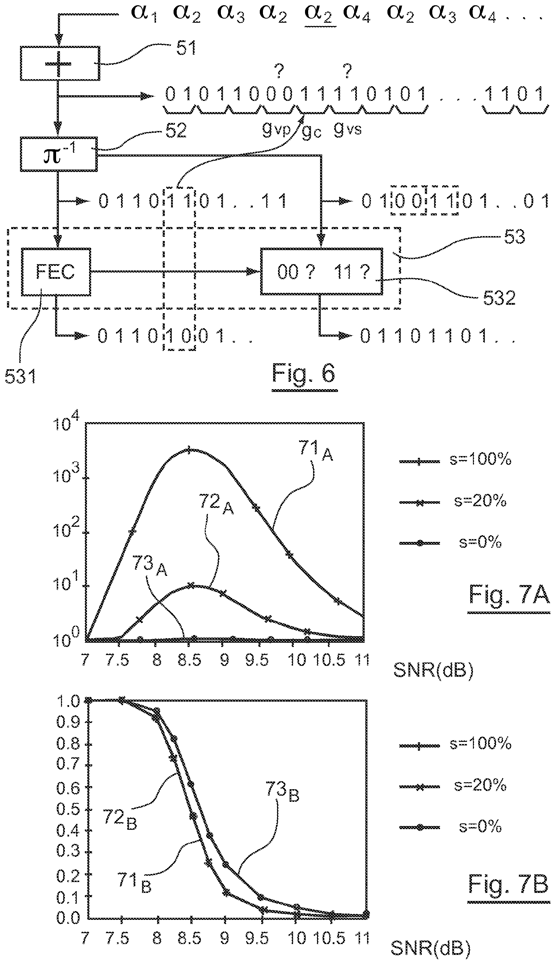

On présente ci-après, en relation avec la figure 6, un exemple de mise en oeuvre de l'étape de décodage 53, lors de la démodulation de symboles reçus correspondant à des symboles modulés ayant subis un codage correcteur d'erreurs délivrant deux mots de code, un entrelacement, et une modulation de phase à 4 états de type QPSK, tel que présenté en relation avec la figure 3B.

A l'issue de l'étape de démodulation différentielle 51, on considère que la séquence démodulée obtenue est formée des groupes successifs suivants : '01', '01', '10', '0̲0̲', '1̲1̲', '11', '01', '01', ..., '11', '01'. Cette séquence est formée de groupes de bits tels que deux groupes consécutifs appartiennent à des mots de code différents. On rappelle que la séquence entrelacée à l'issue de l'étape d'entrelacement 22 mise en oeuvre côté modulation comprenait les groupes successifs suivants : '01', '01', '10', '10', '10', '11', '01', '01', ..., '11', '01' (voir figure 3B).

A l'issue de l'étape de désentrelacement 52, on obtient les deux mots de code suivants :

- premier mot de code : '01', '10', '11', '01', ..., '11' ;
- deuxième mot de code : '01', '00', '11', '01', ..., '01'.

Ces mots de code sont alors décodés au cours d'une étape de décodage 53.

Pour ce faire, on utilise une technique de décodage classique FEC 531 pour décoder le premier mot de code, puis on se sert du résultat de ce décodage classique pour localiser et corriger 532 les erreurs du deuxième mot de code. Il n'est donc pas nécessaire de réitérer tous les calculs classiques de décodage pour le deuxième mot de code.

Plus précisément, lorsque le module de décodage FEC 531 a détecté et corrigé une erreur dans le premier mot de code, affectant un groupe de bits dit groupe courant, il est certain qu'un groupe adjacent à ce groupe courant dans la séquence démodulée, appartenant donc au deuxième mot de code, est aussi erroné. En référence à la figure 6, lorsque le module de décodage FEC 531 a détecté une erreur affectant le groupe courant $g_c$ ('11'), le groupe voisin précédant $g_{vp}$ ('00') et/ou le groupe voisin suivant $g_{vs}$ ('11') présentent donc au moins une erreur.

On présente ci-après différentes techniques permettant de déterminer si l'erreur affecte le groupe voisin précédant $g_{vp}$ ('00'), le groupe voisin suivant $g_{vs}$ ('11'), ou ces deux groupes voisins. Ces différentes techniques peuvent être combinées.

Selon une première technique, on calcule la fiabilité des symboles reçus pour savoir s'il faut corriger chacun des groupes voisins ou juste le moins fiable d'entre eux. Cette décision est réalisée en fixant un seuil $s$, permettant de définir si les deux symboles reçus sont équivalemment fiables ou pas. La valeur de ce seuil $s$ influe sur la complexité de décodage.

On affecte ainsi une première valeur de confiance au symbole reçu obtenu à partir du groupe voisin précédant $g_{vp}$ ('00'), correspondant au point $\alpha_2$ de la constellation selon notre exemple, et une deuxième valeur de confiance au symbole reçu obtenu à partir du groupe courant $g_c$ ('11'), correspondant au point $\alpha_4$ de la constellation selon notre exemple.

Par exemple, ces valeurs de confiance sont déterminées à partir du logarithme du rapport de vraisemblance (LLR, en anglais « Log Likelihood ratio ») associé au symbole reçu correspondant :

$$LLR = \log \frac{P\left(e = \alpha_r \middle| r\right)}{P\left(e \neq \alpha_r \middle| r\right)}$$

où $e$ est le symbole émis (encore appelé symbole modulé dans la description), $r$ le symbole QPSK reçu, et $\alpha_r$ le point de la constellation correspondant au symbole reçu.

Si l'on considère que les valeurs des logarithmes de rapport de vraisemblance sont normalisées, ce seuil prédéterminé $s$ peut s'exprimer en pourcentage. Dans ce cas, si le seuil est égal à 100%, cela signifie que les deux symboles reçus sont équivalemment fiable et aucune décision n'est prise. On considère donc qu'il faut corriger chacun des groupes voisins. Si le seuil est égal à 0%, cela signifie qu'une décision « dure » est prise, et qu'un symbole reçu est plus fiable qu'un autre. On considère donc qu'il faut corriger uniquement le groupe voisin conduisant à la valeur de logarithme de rapport de vraisemblance la plus faible. Dans ce cas, la correction du deuxième mot de code est mise en oeuvre pour le groupe voisin $g_{vp}$ ('00') précédent le groupe courant $g_c$ ('11') dans la séquence démodulée si la première valeur de confiance est inférieure à la deuxième valeur de confiance, ou pour le groupe voisin $g_{vs}$ ('11') suivant le groupe courant $g_c$ ('11') dans la séquence démodulée si la deuxième valeur de confiance est inférieure à la première valeur de confiance.

On considère selon notre exemple que le seuil est égal à 0%. On considère également que la première valeur de confiance est inférieure à la deuxième valeur de confiance. C'est donc le groupe voisin $g_{vp}$ précédant ('00') qui comporte une erreur.

Pour savoir quelle correction appliquer une fois que l'on a déterminé qu'au moins une erreur affecte le groupe voisin précédant $g_{vp}$ ('00'), on se base sur une liste de configurations d'erreurs pré-établie, et on essaie toutes les configurations possibles.

Pour établir cette liste de configurations d'erreurs, on considère que chaque transition peut être mesurée en nombre de quadrant, pour une modulation QPSK. Ainsi, le groupe de bits '01' correspond par exemple à une transition de '1' quadrant. On peut donc mesurer les erreurs en nombre de quadrants. Par exemple, la réception du groupe '11', correspondant à une transition de deux quadrants, au lieu du groupe '01', correspondant à une transition d'un quadrant, correspond à une erreur de '-1' quadrant.

Si on appelle $Nerr_i$ la $i^{ème}$ erreur, en nombre de quadrants, produite par $k$ erreurs de transmission consécutives, on a :

$$\sum_{i=1}^{k+1} Nerr_i = 0 \bmod(4)$$

On obtient ainsi les configurations suivantes pour une erreur de transmission ($k = 1$) et deux erreurs de transmission successives ($k = 2$) :

| k | $Nerr_1$ | $Nerr_2$ | $Nerr_3$ |
|---|---|---|---|
| 1 | +1 | -1 | |
| | -1 | +1 | |
| | +2 | -2 | |
| 2 | +1 | +1 | +2 |
| | +2 | +1 | +1 |
| | -1 | -1 | +2 |
| | +2 | -1 | -1 |
| | +1 | +2 | -1 |
| | -1 | +2 | +1 |
| | +2 | 0 | +2 |
| | +1 | 0 | -1 |
| | -1 | 0 | +1 |

Si l'on considère une seule erreur de transmission ($k$ = 1), une seule correction est possible pour le deuxième mot de code selon notre exemple. Ainsi, si le module de décodage FEC 531 a trouvé une erreur de +1 quadrant sur le groupe courant (réception du groupe '11' au lieu du groupe '10'), alors l'erreur sur le groupe voisin précédant $g_{vp}$ est de -1 quadrant (réception du groupe '00' au lieu du groupe '10'). En effet, la somme des erreurs doit être égale à 0. La correction appliquée au deuxième mot de code correspond donc à l'inverse de celle appliquée au premier mot de code grâce au décodage classique (algébrique ou autre).

Dans le cas d'erreurs de transmission successives ($k \geq 2$), plusieurs configurations d'erreurs sont probables et la complexité du décodage augmente. On étudie alors les corrections possibles que l'on pourrait appliquer au deuxième mot de code à partir de la liste de configurations d'erreurs. On définit ainsi un ensemble de mots de code « candidats » pour le deuxième mot de code. En étudiant ces mots de code candidats, on évite de réaliser un décodage classique du deuxième mot de code.

Plus précisément, afin de déterminer un mot de code « valide » parmi l'ensemble de mots de code candidats, c'est-à-dire un mot de code qui correspond à une bonne correction, on calcule le syndrome de chaque mot de code candidat. Par exemple, un tel syndrome peut être déterminé en utilisant la technique décrite par J. G. Proakis dans « Digital Communications » (troisième édition, New York: McGraw-Hill, 1989). Par exemple, pour un module de codage FEC mettant en oeuvre un code linéaire en blocs de type Reed-Solomon, BCH, LDPC, etc, chaque mot de code c doit être orthogonal à la matrice de contrôle de parité $H$ du code : $c.H^T = 0$. Le syndrome associé à ce module de codage est donc $synd = c.H^T$.

Si le syndrome obtenu est nul pour un mot de code candidat, cela signifie que le mot de code candidat est un mot de code valide. On corrige donc le deuxième mot de code en le remplaçant par le mot de code candidat valide.

Si on ne trouve aucun syndrome égal à 0 pour les différents mots de code candidats, cela signifie qu'aucun mot de code n'est valide. En d'autres termes, aucune des corrections proposées n'est correcte. On procède alors au décodage du deuxième mot de code, en utilisant une technique de décodage classique FEC.

Selon une deuxième technique, il est également possible de déterminer (si une erreur affecte le groupe voisin précédant $g_{vp}$ ('00'), le groupe voisin suivant $g_{vs}$ ('11'), ou ces deux groupes voisins, en utilisant directement la technique du syndrome.

Ainsi, connaissant l'erreur affectant le groupe courant, par exemple égale à +1, on sait que l'erreur affectant le groupe voisin précédant $g_{vp}$ ('00') ou le groupe voisin suivant $g_{vs}$ ('11') est égale à -1. On détermine donc un ensemble de mots de code candidats en modifiant les valeurs des bits du groupe voisin précédant $g_{vp}$ et/ou du groupe voisin suivant $g_{vs}$ dans le deuxième mot de code afin d'obtenir une erreur égale à -1. On sélectionne ensuite parmi les mots de code candidats celui qui présente un syndrome égal à 0, s'il existe.

Afin de réduire le nombre de mots de code candidats, il est possible de combiner cette deuxième technique à la première technique, en affectant des valeurs de confiance aux symboles reçus, comme décrit précédemment.

Finalement, l'algorithme de décodage selon l'invention met en oeuvre les étapes suivantes :

- décodage classique du premier mot de code ;
- si le deuxième mot de code est valide :

  ◦ on arrête l'algorithme de décodage ;

- sinon :

  ◦ on teste des configurations d'erreurs possibles en utilisant des mots de code candidats ;
  ◦ s'il y a un mot de code candidat valide :

    ▪ on arrête l'algorithme de décodage ;

  ◦ sinon :

    ▪ on met en oeuvre un décodage classique du deuxième mot de code.

Par ailleurs, on a décrit en relation avec la figure 6 un exemple de mise en oeuvre de l'étape de décodage 53, lors de la démodulation de symboles reçus correspondants à des symboles modulés ayant subis un codage correcteur d'erreurs délivrant deux mots de code, un entrelacement, et une modulation QPSK.

Bien entendu, la technique de décodage à complexité réduite selon l'invention peut être mise en oeuvre quelque soit le nombre de mots de code délivrés par le codage correcteur d'erreurs côté émission.

Ainsi, si l'on considère un codage correcteur d'erreurs délivrant trois mots de code, et un entrelacement de ces trois mots de code selon l'invention, on peut décoder classiquement deux mots de code sur les trois, et en déduire le décodage du troisième mot de code. La complexité de décodage est dans ce cas réduite d'un tiers. On note à cet effet, que toutes les configurations de deux erreurs de transmission successives sont détectables et corrigeables.

Si l'on considère un codage correcteur d'erreurs délivrant quatre mots de code, et un entrelacement de ces quatre mots de code selon l'invention, on peut décoder classiquement deux mots de code sur les quatre. On peut alors conditionner le décodage d'un troisième mot de code au fait de trouver un mot de code valide pour ce troisième mot de code. Ainsi, si on dispose d'un mot de code valide, on décode le troisième puis le quatrième mot de code en tenant compte des corrections apportées aux premier et deuxième mots de code. Si on ne dispose pas d'un mot de code valide, on décode le troisième mot de code de manière classique, et on cherche à décoder le quatrième mot de code en tenant compte des corrections apportées aux premier, deuxième et troisième mots de code.

Ainsi, on note que l'entrelacement de plusieurs mots de code offre la possibilité de détecter et corriger directement beaucoup de configurations d'erreurs.

En particulier, la complexité de l'algorithme proposé dépend à la fois du nombre de syndromes calculés et du nombre de décodages effectués, selon le nombre de mots de code entrelacés.

Les figures 7A et 7B illustrent le nombre de syndromes calculés (figure 7A) et le nombre de décodages effectués (figure 7B) en moyenne pour le second mot de code (dans le cas où seulement deux mots de code sont entrelacés), en fonction du rapport signal à bruit SNR, pour un codage correcteur d'erreurs de type BCH(1023,883) délivrant deux mots de code et une modulation de type QPSK, et pour différents niveaux de seuil $s$ pour la valeur de confiance :

- $s$ =100%, courbes $71_A$ et $71_B$ ;
- $s$ = 20%, courbes $72_A$ et $72_B$ ;
- $s$ = 0%, courbes $73_A$ et $73_B$ ;

On constate sur ces courbes qu'à fort SNR et pour un seuil de 0%, c'est-à-dire lorsqu'on choisit de corriger le groupe de bits correspondant au symbole QPSK le moins fiable, le nombre de syndromes et de décodages classiques est négligeable.

On ne réalise donc qu'un décodage classique pour le premier mot de code, et on en déduit directement le deuxième, ce qui correspond à une réduction de 50% de la complexité de décodage par rapport aux solutions classiques de l'art antérieur.

On note également que, puisqu'il est toujours possible d'effectuer un décodage classique du deuxième mot de code si l'on ne trouve pas de mot de code valide, il n'y a aucune perte de gain accompagnant la réduction de complexité.

La solution proposée par l'invention permet ainsi d'obtenir un gain de codage significatif et une réduction de complexité pouvant aller jusqu'à 50%, ce qui est un atout considérable dans le cas de transmission optique très haut débit notamment. Elle repose sur la mise en oeuvre d'une modulation différentielle, et est donc transposable à toute famille de codes correcteurs d'erreurs et à toutes tailles de constellation.

*5.5 Réduction de redondance*

L'algorithme de décodage proposé ci-dessus montre comment le décodage d'un premier mot de code permet de déduire totalement le décodage d'un deuxième mot de code. Il n'apparaît donc pas nécessaire de coder les bits d'information correspondant au deuxième mot de code et d'y ajouter des bits de redondance, si ces bits de redondance ne sont pas utilisés pour le décodage.

Néanmoins, dans certaines situations, le décodage classique du deuxième mot de code doit être réalisé (lorsqu'on n'a pas trouvé de mot de code valide). Il apparaît donc préférable d'encoder les bits d'information.

On propose donc, selon une caractéristique particulière de l'invention, de mettre en oeuvre des codes correcteurs d'erreurs distincts, délivrant chacun un mot de code distinct. Les mots de code entrelacés peuvent ainsi provenir de modules de codage FEC mettant en oeuvre des codes correcteurs d'erreurs différents, et générant des mots de code de taille différente (présentant plus ou moins de redondance).

Selon cette caractéristique particulière, on utilise dans le deuxième module de codage un code correcteur d'erreurs moins puissant que celui utilisé dans le premier module de codage, et qui génère donc moins de bits de redondance.

Ainsi, si on note $C_1(n_1,k_1)$ le code utilisé dans le premier module de codage (premier code), et $C_2(n_2,k_2)$ le code utilisé dans le deuxième module de codage (deuxième code), avec $n_2 > n_1$, la redondance totale (en nombre de bits de redondance par rapport au nombre de bit total) est définie par :

$$r = \frac{(n_1 + n_2) - k_1 - k_2}{n_1 + n_2}.$$

$$r_1 = \frac{n_1 - k_1}{n_1}$$

On a aussi $r < r_1$, *avec* qui correspondrait à la redondance totale si les premier et deuxième modules de codage étaient identiques.

On note que le deuxième code, moins puissant, ne peut pas décoder les erreurs aussi bien que le premier code. Il en résulte donc un palier d'erreur si un décodage classique du deuxième mot de code est mis en oeuvre.

Pour abaisser ce palier, on doit considérer le plus de configurations d'erreurs possible, comme par exemple les configurations de deux erreurs successives listées précédemment (k = 2).

On note également que même si aucune des corrections proposées ne rend un mot de code valide, l'une de ces corrections doit être proche de la bonne correction. On choisit donc d'effectuer un décodage classique sur la correction qui semble la plus probable, par exemple celle qui correspond aux symboles QPSK les moins fiables. On considère ainsi un algorithme en deux passes, comprenant une première passe au cours de laquelle on corrige certaines erreurs du deuxième mot de code en les déduisant de la correction du premier mot de code, puis une deuxième passe au cours de laquelle on utilise un décodage classique pour corriger les erreurs restantes après la première passe.

La capacité de correction nécessaire pour le deuxième module de codage générant le deuxième mot de code dépend donc du nombre d'erreurs restantes après la première passe (erreurs « manquées ») et donc de la qualité du décodage.

*5.6 Structure simplifiée des dispositifs de modulation et de démodulation correspondants*

On présente finalement, en relation avec les figures 8A et 8B, la structure simplifiée d'un dispositif de modulation et d'un dispositif de démodulation mettant respectivement en oeuvre une technique de modulation et une technique de démodulation selon l'un des exemples de réalisation décrits ci-dessus.

Un tel dispositif de modulation comprend une mémoire 81, une unité de traitement 82, équipée par exemple d'un microprocesseur $\mu$P, et pilotée par le programme d'ordinateur 83, mettant en oeuvre le procédé de modulation selon l'invention. A l'initialisation, les instructions de code du programme d'ordinateur 83 sont par exemple chargées dans une mémoire RAM avant d'être exécutées par le processeur de l'unité de traitement 82. L'unité de traitement 82 reçoit en entrée une séquence binaire source $b_s$ formée d'une pluralité de mots source. Le microprocesseur de l'unité de traitement 82 met en oeuvre les étapes du procédé de modulation décrit précédemment, selon les instructions du programme d'ordinateur 83, pour coder, entrelacer, et moduler la séquence binaire source, et émettre des symboles modulés *e*. Pour cela, le dispositif de modulation comprend, outre la mémoire tampon 81, des moyens de codage correcteur d'erreurs de la pluralité de mots source, délivrant une pluralité de mots de code, des moyens d'entrelacement des mots de code, délivrant une séquence entrelacée, et des moyens de modulation différentielle de la séquence entrelacée, délivrant des symboles modulés, tels que décrits précédemment. Ces moyens sont pilotés par le microprocesseur de l'unité de traitement 82. L'unité de traitement 82 transmet donc à destination d'un récepteur, via un canal de transmission, un signal modulé comprenant des symboles modulés.

Le dispositif de démodulation de la figure 8B comprend quant à lui une mémoire 84, une unité de traitement 85, équipée par exemple d'un microprocesseur $\mu$P, et pilotée par le programme d'ordinateur 86, mettant en oeuvre le procédé de démodulation selon l'invention. A l'initialisation, les instructions de code du programme d'ordinateur 86 sont par exemple chargées dans une mémoire RAM avant d'être exécutées par le processeur de l'unité de traitement 85. L'unité de traitement 85 reçoit en entrée des symboles reçus *r*. Le microprocesseur de l'unité de traitement 85 met en oeuvre les étapes du procédé de démodulation décrit précédemment, selon les instructions du programme d'ordinateur 86, pour démoduler, désentrelacer, décoder les symboles reçus *r*, et reconstruire une séquence binaire $\hat{b}_s$. Pour cela, le dispositif de démodulation comprend, outre la mémoire tampon 84, des moyens de démodulation différentielle des symboles reçus, délivrant une séquence démodulée, des moyens de désentrelacement de la séquence démodulée, délivrant une pluralité de mots de code, et des moyens de décodage de mots de code, délivrant la séquence binaire reconstruite, tels que décrits précédemment. Ces moyens sont pilotés par le microprocesseur de l'unité de traitement 85.

**Revendications**

1. Procédé de modulation d'une séquence binaire source formée d'une pluralité de mots source, délivrant des symboles modulés, ledit procédé mettant en oeuvre :

   - un codage correcteur d'erreurs (21) de ladite pluralité de mots source, mettant en oeuvre un unique module de codage mettant en oeuvre un code correcteur d'erreurs, ou plusieurs modules de codage mettant chacun en oeuvre un code correcteur d'erreurs distinct, délivrant une pluralité de mots de code,
   lesdits mots source étant codés successivement ;
   - un entrelacement (22) desdits mots de code, délivrant une séquence entrelacée ;
   - une modulation différentielle (23) de ladite séquence entrelacée, délivrant des symboles modulés ;

   chaque mot de code est décomposé en au moins un groupe présentant un nombre de bits égal au logarithme en base deux d'un nombre d'états de ladite modulation différentielle,
   ladite étape d'entrelacement (22) répartit lesdits groupes dans ladite séquence entrelacée, de façon que deux groupes adjacents dans ladite séquence entrelacée appartiennent à des mots de code distincts.

**2.** Procédé de modulation selon la revendication 1, **caractérisé en ce que** ledit codage correcteur d'erreurs (21) met en oeuvre au moins deux codes correcteurs d'erreurs distincts, délivrant chacun des mots de code distincts.

**3.** Procédé de modulation selon la revendication 2, **caractérisé en ce que**, lorsque lesdits mots de code obtenus par la mise en oeuvre de codes correcteurs d'erreurs distincts présentent une longueur différente, ladite étape d'entrelacement (22) entrelace lesdits groupes jusqu'à avoir réparti tous les groupes du mot de code présentant la plus petite longueur.

**4.** Procédé de modulation selon l'une quelconque des revendications 1 à 3, **caractérisé en ce que**, lesdits mots de code comprenant des bits d'information et des bits de redondance, chaque mot de code est décomposé en au moins un groupe de bits d'information et au moins un groupe de bits de redondance, et **en ce que** ladite étape d'entrelacement (22) répartit lesdits groupes de bits d'information dans ladite séquence entrelacée, de façon que deux groupes de bits d'information adjacents dans ladite séquence entrelacée appartiennent à des mots de code distincts.

**5.** Produit programme d'ordinateur exécutable par un processeur, **caractérisé en ce qu'**il comprend des instructions de code de programme pour la mise en oeuvre du procédé de modulation selon l'une au moins des revendications 1 à 4.

**6.** Dispositif de modulation d'une séquence binaire source formée d'une pluralité de mots source, délivrant des symboles modulés, ledit dispositif comprend :

- des moyens de codage correcteur d'erreurs (21) de ladite pluralité de mots source, mettant en oeuvre un unique module de codage mettant en oeuvre un code correcteur d'erreurs, ou plusieurs modules de codage mettant chacun en oeuvre un code correcteur d'erreurs distinct, délivrant une pluralité de mots de code, lesdits mots source étant codés successivement ;
- des moyens d'entrelacement (22) desdits mots de code, délivrant une séquence entrelacée ;
- des moyens de modulation différentielle (23) de ladite séquence entrelacée, délivrant des symboles modulés ;

chaque mot de code est décomposé en au moins un groupe présentant un nombre de bits égal au logarithme en base deux d'un nombre d'états d'une modulation différentielle mise en oeuvre par lesdits moyens de modulation différentielle ;

lesdits moyens d'entrelacement (22) répartissent lesdits groupes dans ladite séquence entrelacée, de façon que deux groupes adjacents dans ladite séquence entrelacée appartiennent à des mots de code distincts.

**7.** Signal formé de symboles modulés, lesdits symboles modulés sont obtenus à partir d'une séquence binaire source formée d'une pluralité de mots source, ayant subi avant émission :

- un codage correcteur d'erreurs de ladite pluralité de mots source, mettant en oeuvre un unique module de codage mettant en oeuvre un code correcteur d'erreurs, ou plusieurs modules de codage mettant chacun en oeuvre un code correcteur d'erreurs distinct, délivrant une pluralité de mots de code, lesdits mots source étant codés successivement ;
- un entrelacement desdits mots de code, délivrant une séquence entrelacée ;
- une modulation différentielle de ladite séquence entrelacée, délivrant des symboles modulés ;

chaque mot de code étant décomposé en au moins un groupe présentant un nombre de bits égal au logarithme en base deux d'un nombre d'états de ladite modulation différentielle ;

et ledit entrelacement répartissant lesdits groupes dans ladite séquence entrelacée, de façon que deux groupes adjacents dans ladite séquence entrelacée appartiennent à des mots de code distincts.

**8.** Procédé de démodulation de symboles reçus, correspondant à des symboles modulés après passage dans un canal de transmission, délivrant une séquence binaire reconstruite, lesdits symboles modulés étant obtenus à partir d'une séquence binaire source formée d'une pluralité de mots source, ayant subi avant émission :

- un codage correcteur d'erreurs de ladite pluralité de mots source, mettant en oeuvre un unique module de codage mettant en oeuvre un code correcteur d'erreurs, ou plusieurs modules de codage mettant chacun en oeuvre un code correcteur d'erreurs distinct, délivrant une pluralité de mots de code, lesdits mots source étant codés successivement ;
- un entrelacement desdits mots de code, délivrant une séquence entrelacée ;
- une modulation différentielle de ladite séquence entrelacée, délivrant des symboles modulés ;

chaque mot de code étant décomposé en au moins un groupe présentant un nombre de bits égal au logarithme en base deux d'un nombre d'états de ladite modulation différentielle ; et ledit entrelacement répartissant lesdits groupes dans ladite séquence entrelacée, de façon que deux groupes adjacents dans ladite séquence entrelacée appartiennent à des mots de code distincts,
ledit procédé de démodulation met en oeuvre les étapes suivantes :

- démodulation différentielle (51) desdits symboles reçus, mettant en oeuvre un traitement inverse à la modulation différentielle mise en oeuvre en émission, délivrant une séquence démodulée ;
- désentrelacement (52) de ladite séquence démodulée, mettant en oeuvre un traitement inverse à l'entrelacement mis en oeuvre en émission, délivrant une pluralité de mots de code ;
- décodage (53) desdits mots de code, délivrant ladite séquence binaire reconstruite.

9. Procédé de démodulation selon la revendication 8, **caractérisé en ce que** ledit décodage (53) met en oeuvre les étapes suivantes :

◦ correction, à partir d'au moins un code correcteur d'erreurs, d'au moins un premier mot de code comprenant au moins un groupe comprenant au moins un bit erroné, dit groupe courant, délivrant un premier mot de code corrigé ;
◦ correction, à partir dudit premier mot de code corrigé, d'au moins un mot de code distinct comprenant un groupe adjacent audit groupe courant dans ladite séquence démodulée, dit groupe voisin.

10. Procédé de démodulation selon la revendication 9, **caractérisé en ce qu'**il comprend une étape d'affectation d'une première valeur de confiance au symbole reçu obtenu à partir dudit groupe voisin précédent ledit groupe courant dans ladite séquence démodulée, et d'une deuxième valeur de confiance au symbole reçu obtenu à partir dudit groupe courant, et **en ce que** ladite étape de correction dudit mot de code distinct est mise en oeuvre pour le groupe voisin précédent ledit groupe courant dans ladite séquence démodulée et/ou pour le groupe voisin suivant ledit groupe courant dans ladite séquence démodulée en tenant compte desdites valeurs de confiance.

11. Procédé de démodulation selon la revendication 10, **caractérisé en ce que** lesdites valeurs de confiance sont égales au logarithme du rapport de vraisemblance associé au symbole reçu correspondant.

12. Procédé de démodulation selon l'une quelconque des revendications 9 à 11, **caractérisé en ce que** ladite étape de correction dudit mot de code distinct comprend :

- une étape de détermination d'au moins un mot de code candidat pour ledit mot de code distinct ;
- une étape de détermination du syndrome associé au ou auxdits mots de code candidats ;
- une étape de sélection dudit mot de code candidat présentant un syndrome nul, délivrant le mot de code distinct corrigé.

13. Produit programme d'ordinateur exécutable par un processeur, **caractérisé en ce qu'**il comprend des instructions de code de programme pour la mise en oeuvre du procédé de démodulation selon l'une au moins des revendications 8 à 12.

14. Dispositif de démodulation de symboles reçus, correspondant à des symboles modulés après passage dans un canal de transmission, délivrant une séquence binaire reconstruite,
lesdits symboles modulés étant obtenus à partir d'une séquence binaire source formée d'une pluralité de mots source, par un traitement de dispositif selon la revendication 6, ledit dispositif de démodulation comprend :

- des moyens de démodulation différentielle (51) desdits symboles reçus, mettant en oeuvre un traitement inverse à la modulation différentielle mise en oeuvre en émission, délivrant une séquence démodulée ;
- des moyens de désentrelacement (52) de ladite séquence démodulée, mettant en oeuvre un traitement inverse à l'entrelacement mis en oeuvre en émission, délivrant une pluralité de mots de code ;
- des moyens de décodage (53) desdits mots de code, délivrant ladite séquence binaire reconstruite.

**Patentansprüche**

1. Verfahren zur Modulation einer Quellbitfolge, die aus einer Vielzahl von Quellwörtern gebildet wird, die modulierte Symbole liefern,
wobei das Verfahren ausführt:

- eine Fehlerkorrekturkodierung (21) der Vielzahl von Quellwörtern, die ein einzelnes Kodierungsmodul ausführt, das einen Fehlerkorrekturkode ausführt, oder mehrere Kodierungsmodule, wobei jedes eine unterschiedliche Fehlerkorrekturkodierung ausführt, die eine Vielzahl von Kodewörtern liefert,

wobei die Quellwörter nacheinander kodiert werden;

- ein Verschachteln (22) der Kodewörter, die eine verschachtelte Abfolge liefern;
- eine Differentialmodulation (23) der verschachtelten Abfolge, die modulierten Symbole liefert;

wobei jedes Kodewort in mindestens eine Gruppe zerlegt wird, die eine Bitzahl gleich dem Zweierlogarithmus einer Anzahl von Zuständen der Differentialmodulation aufweist, wobei der Schritt des Verschachtelns (22) die Gruppen in der verschachtelten Abfolge derart verteilt, dass zwei angrenzende Gruppen in der verschachtelten Abfolge zu unterschiedlichen Kodewörtern gehören.

2. Verfahren zur Modulation nach Anspruch 1, **dadurch gekennzeichnet, dass** die Fehlerkorrekturkodierung (21) mindestens zwei unterschiedliche Fehlerkorrekturkodes umsetzt, die jeder unterschiedliche Kodewörter liefern.

3. Verfahren zur Modulation nach Anspruch 2, **dadurch gekennzeichnet, dass** der Schritt des Verschachtelns (22) die Gruppen verschachtelt, bis alle Gruppen des Kodeworts, das die kleinste Länge aufweist, verteilt sind, wenn die durch die Ausführung der unterschiedlichen Fehlerkorrekturkodes erhaltenen Kodewörter eine unterschiedliche Länge aufweisen.

4. Verfahren zur Modulation nach einem der Ansprüche 1 bis 3, **dadurch gekennzeichnet, dass**, da die Kodewörter Informationsbits und Redundanzbits umfassen, jedes Kodewort in mindestens eine Gruppe von Informationsbits und mindestens eine Gruppe von Redundanzbits zerlegt wird, und dass der Schritt des Verschachtelns (22) die Gruppen von Informationsbits in der verschachtelten Abfolge derart verteilt, dass zwei Gruppen von angrenzenden Informationsbits in der verschachtelten Abfolge zu unterschiedlichen Kodewörtern gehören.

5. Computerprogrammprodukt, das durch einen Prozessor ausführbar ist, **dadurch gekennzeichnet, dass** es Programmkodebefehle für die Ausführung des Modulationsverfahrens nach mindestens einem der Ansprüche 1 bis 4 umfasst.

6. Vorrichtung zur Modulation einer Quellbitfolge, die aus einer Vielzahl von Quellwörtern gebildet wird, die modulierte Symbole liefert, wobei die Vorrichtung umfasst:

- Fehlerkorrekturkodierungsmittel (21) der Vielzahl von Quellwörtern, die ein einzelnes Kodierungsmodul ausführen, das einen Fehlerkorrekturkode ausführt, oder mehrere Kodierungsmodule, wobei jedes einen unterschiedlichen Fehlerkorrekturkode ausführt, der eine Vielzahl von Kodewörtern liefert,

wobei die Quellwörter nacheinander kodiert werden;

- Verschachtelungsmittel (22) der Kodewörter, die eine verschachtelte Abfolge liefern;
- Differentialmodulationsmittel (23) der verschachtelten Abfolge, die modulierte Symbole liefern;

wobei jedes Kodewort in mindestens eine Gruppe zerlegt wird, die eine Bitzahl gleich dem Zweierlogarithmus einer Anzahl von Zuständen einer durch die Differentialmodulationsmittel ausgeführten Differentialmodulation aufweist;
wobei die Verschachtelungsmittel (22) die Gruppen in der verschachtelten Abfolge derart verteilen, dass zwei angrenzende Gruppen in der verschachtelten Abfolge zu unterschiedlichen Kodewörtern gehören.

7. Signal, das aus modulierten Symbole gebildet wird, wobei die modulierten Symbole aus einer Quellbitfolge erhalten werden, die aus einer Vielzahl von Quellwörtern gebildet wird, die vor einer Emission:

- einer Fehlerkorrekturkodierung der Vielzahl von Quellwörtern, die ein einzelnes Kodierungsmodul ausführt, das einen Fehlerkorrekturkode ausführt, oder mehrere Kodierungsmodule, wobei jedes einen unterschiedlichen Fehlerkorrekturkode ausführt, der eine Vielzahl von Kodewörtern liefert,
wobei die Quellwörter nacheinander kodiert werden;
- einem Verschachteln der Kodewörter, die eine verschachtelte Abfolge liefern;
- einer Differentialmodulation der verschachtelten Abfolge, die modulierte Symbole liefert,

unterzogen worden sind;
wobei jedes Kodewort in mindestens eine Gruppe zerlegt wird, die eine Bitzahl gleich dem Zweierlogarithmus einer Anzahl von Zuständen der Differentialmodulation aufweist;
und wobei das Verschachteln die Gruppen in der verschachtelten Abfolge derart verteilt, dass zwei angrenzende Gruppen in der verschachtelten Abfolge zu unterschiedlichen Kodewörtern gehören.

8. Verfahren zur Demodulation von empfangenen Symbolen, die modulierten Symbolen nach Durchlaufen eines Übertragungskanals entsprechen, die eine rekonstruierte Bitfolge liefern, wobei die modulierten Symbole aus einer Quellbitfolge erhalten werden, die aus einer Vielzahl von Quellwörtern gebildet wird, die vor einer Emission:

- einer Fehlerkorrekturkodierung der Vielzahl von Quellwörtern, die ein einzelnes Kodierungsmodul ausführt, das eine Fehlerkorrekturkodierung ausführt, oder mehrere Kodierungsmodule, wobei jedes einen unterschiedlichen Fehlerkorrekturkode ausführt, der eine Vielzahl von Kodewörtern liefert,

wobei die Quellwörter nacheinander kodiert werden;

- einem Verschachteln der Kodewörter, die eine verschachtelte Abfolge liefern;
- einer Differentialmodulation der verschachtelten Abfolge, die modulierte Symbole liefert,

unterzogen worden sind;

wobei jedes Kodewort in mindestens eine Gruppe zerlegt wird, die eine Bitzahl gleich dem Zweierlogarithmus einer Anzahl von Zuständen der Differentialmodulation aufweist;

und das Verschachteln die Gruppen in der verschachtelten Abfolge derart verteilt, dass zwei angrenzende Gruppen in der verschachtelten Abfolge zu unterschiedlichen Kodewörtern gehören,

wobei das Demodulationsverfahren die folgenden Schritte umsetzt:

- Differentialdemodulation (51) der empfangenen Symbole, die eine zu der beim Senden ausgeführten Differentialmodulation umgekehrte Verarbeitung ausführt, die eine demodulierte Abfolge liefert;
- Entschachteln (52) der demodulierten Abfolge, das eine zu dem beim Senden ausgeführten Verschachteln umgekehrte Verarbeitung ausführt, das eine Vielzahl von Kodewörtern liefert;
- Dekodieren (53) der Kodewörter, das die rekonstruierte Bitfolge liefert.

**9.** Demodulationsverfahren nach Anspruch 8, **dadurch gekennzeichnet, dass** das Dekodieren (53) die folgenden Schritte umsetzt:

◦ Korrektur mindestens eines ersten Kodeworts, ausgehend von mindestens einem Fehlerkorrekturkode, der mindestens eine Gruppe umfasst, die mindestens ein fehlerhaftes Bit umfasst, aktuelle Gruppe genannt, die ein erstes korrigiertes Kodewort liefert;
◦ Korrektur mindestens eines unterschiedlichen Kodeworts, umfassend eine in der demodulierten Abfolge zu der aktuellen Gruppe angrenzende Gruppe, genannt Nachbargruppe, ausgehend von dem ersten korrigierten Kodewort.

**10.** Demodulationsverfahren nach Anspruch 9, **dadurch gekennzeichnet, dass** es einen Zuweisungsschritt eines ersten Vertrauenswerts zu dem in der demodulierten Abfolge von der der aktuellen Gruppe vorhergehenden Nachbargruppe empfangenen Symbolen und eines zweiten Vertrauenswerts zu dem von der aktuellen Gruppe erhaltenen Symbolen umfasst, und dass der Korrekturschritt des unterschiedlichen Kodeworts für die der aktuellen Gruppe vorhergehende Nachbargruppe in der demodulierten Abfolge und/oder für die der aktuellen Gruppe folgende Nachbargruppe in der demodulierten Abfolge unter Berücksichtigung der Vertrauenswerte ausgeführt wird.

**11.** Demodulationsverfahren nach Anspruch 10, **dadurch gekennzeichnet, dass** die Vertrauenswerte gleich dem Logarithmus des mit dem entsprechenden empfangenen Symbol assoziierten Likelihood-Ratios sind.

**12.** Demodulationsverfahren nach einem der Ansprüche 9 bis 11, **dadurch gekennzeichnet, dass** der Korrekturschritt des unterschiedlichen Kodeworts umfasst:

- einen Bestimmungsschritt mindestens eines Kandidatenkodeworts für das unterschiedliche Kodewort;
- einen Bestimmungsschritt des mit dem Kandidatenkodewort bzw. mit den Kandidatenkodewörtern assoziierten Syndroms;
- einen Auswahlschritt des Kandidatenkodeworts, der ein Null-Syndrom aufweist, das das korrigierte unterschiedliche Kodewort liefert.

**13.** Computerprogrammprodukt, das durch einen Prozessor ausführbar ist, **dadurch gekennzeichnet, dass** es Programmkodebefehle für die Ausführung des Demodulationsverfahrens nach mindestens einem der Ansprüche 8 bis 12 umfasst.

**14.** Vorrichtung zur Demodulation von empfangenen Symbolen, die modulierten Symbolen nach Durchlaufen eines Übertragungskanals entsprechen, die eine rekonstruierte Bitfolge liefert, wobei die modulierten Symbole durch eine Verarbeitung der Vorrichtung nach Anspruch 6 von einer aus einer Vielzahl von Quellwörtern gebildeten Quellbitfolge erhalten werden, wobei die Demodulationsvorrichtung umfasst:

- Mittel zur Differentialdemodulation (51) der empfangenen Symbole, die eine zu der beim Senden ausgeführten Differentialmodulation umgekehrte Verarbeitung ausführen, die eine demodulierte Abfolge liefert;
- Mittel zum Entschachteln (52) der demodulierten Abfolge, die eine zu dem beim Senden ausgeführten Verschachteln umgekehrte Verarbeitung ausführen, die eine Vielzahl von Kodewörtern liefert;
- Mittel zum Dekodieren (53) der Kodewörter, die die rekonstruierte Bitfolge liefern.

**Claims**

1. A method for modulating a source binary sequence formed by a plurality of source words, delivering modulated symbols, said method implementing:

   - an error correction encoding (21) of said plurality of source words, implementing a single encoding module implementing an error correction code, or a number of encoding modules, each implementing a distinct error correction code, delivering a plurality of code words, said source words being encoded successively;
   - an interlacing (22) of said code words, delivering an interlaced sequence;
   - a differential modulation (23) of said interlaced sequence, delivering modulated symbols;

   each code word being decomposed into at least one group having a number of bits equal to the base two logarithm of a number of states of said differential modulation, said interlacing step (22) distributing said groups in said interlaced sequence so that two adjacent groups in said interlaced sequence belong to distinct code words.

2. The modulation method according to Claim 1, **characterised in that** said error correction encoding (21) implements at least two distinct error correction codes, each delivering distinct code words.

3. The modulation method according to Claim 2, **characterised in that**, when said code words obtained by the implementation of distinct error correction codes have a different length, said interlacing step (22) interlaces said groups until it has distributed all of the groups of the code word having the smallest length.

4. The modulation method according to any of Claims 1 to 3, **characterised in that**, said code words comprising information bits and redundancy bits, each code word is decomposed into at least one group of information bits and at least one group of redundancy bits, and **in that** said interlacing step (22) distributes said groups of information bits in said interlaced sequence such that two adjacent groups of information bits in said interlaced sequence belong to distinct code words.

5. A computer program product executable by a processor, **characterised in that** it comprises programme code instructions for the implementation of the modulation method according to at least one of Claims 1 to 4.

6. A device for modulating a source binary sequence formed by a plurality of source words, delivering modulated symbols, said device comprising:

   - means for error correction encoding (21) of said plurality of source words, implementing a single encoding module implementing an error correction code, or a number of encoding modules each implementing a distinct error correction code, delivering a plurality of code words, said source words being encoded successively;
   - means for interlacing (22) of said code words, delivering an interlaced sequence;
   - means for differential modulation (33) of said interlaced sequence, delivering modulated symbols;

   each code word being decomposed into at least one group having a number of bits equal to the base two logarithm of a number of states of a differential modulation implemented by said differential modulation means; said interlacing means (22) distributing said groups in said interlaced sequence so that two adjacent groups in said interlaced sequence belong to distinct code words.

7. A signal formed by modulated symbols, said modulated symbols being obtained from a source binary sequence formed by a plurality of source words, having undergone before being emission:

   - an error correction encoding of said plurality of source words, implementing a single encoding module implementing an error correction code, or a number of encoding modules each implementing a distinct error correction code, delivering a plurality of code words, said source words being encoded successively;
   - an interlacing of said code words, delivering an interlaced sequence;
   - a differential modulation of said interlaced sequence, delivering modulated symbols;

   each code word being decomposed into at least one group having a number of bits equal to the base two logarithm of a number of states of said differential modulation; and said interlacing distributing said groups in said interlaced sequence so that two adjacent groups in said interlaced sequence belong to distinct code words.

8. A method for demodulating received symbols, corresponding to symbols modulated after passage in a transmission channel, delivering a reconstructed binary sequence, said modulated symbols being obtained from a source binary sequence formed by a plurality of source words, having undergone before emission:

- an error correction encoding of said plurality of source words, implementing a single encoding module implementing an error correction code, or a number of encoding modules each implementing a distinct error correction code, delivering a plurality of code words, said source words being encoded successively;
- an interlacing of said code words, delivering an interlaced sequence;
- a differential modulation of said interlaced sequence, delivering modulated symbols;

each code word being decomposed into at least one group having a number of bits equal to the base two logarithm of a number of states of said differential modulation; and said interlacing distributing said groups in said interlaced sequence so that two adjacent groups in said interlaced sequence belong to distinct code words, said demodulation method implementing the following steps:

- differential demodulation (51) of said received symbols, implementing processing that is the inverse of the differential modulation implemented when sending, delivering a demodulated sequence;
- de-interlacing (52) said demodulated sequence, implementing processing that is the inverse of the interlacing implemented when sending, delivering a plurality of code words;
- decoding (53) said code words, delivering said reconstructed binary sequence.

**9.** The demodulation method according to Claim 8, **characterised in that** said decoding (53) implements the following steps:

◦ correcting, from at least one error correction code, at least one first code word comprising at least one group comprising at least one erroneous bit, called current group, delivering a first corrected code word;
◦ correcting, from said first corrected code word, at least one distinct code word comprising a group adjacent to said current group in said demodulated sequence, called neighbouring group.

**10.** The demodulation method according to Claim 9, **characterised in that** it comprises a step of assigning a first confidence value to the received symbol obtained from said neighbouring group preceding said current group in said demodulated sequence, and a second confidence value to the received symbol obtained from said current group, and **in that** said step of correcting said distinct code word is implemented for the neighbouring group preceding said current group in said demodulated sequence and/or for the neighbouring group following said current group in said demodulated sequence taking into account said confidence values.

**11.** The demodulation method according to Claim 10, **characterised in that** said confidence values are equal to the logarithm of the likelihood ratio associated with the corresponding received symbol.

**12.** The demodulation method according to any of Claims 9 to 11, **characterised in that** said step of correcting said distinct code word comprises:

- a step of determining at least one candidate code word for said distinct code word;
- a step of determining the syndrome associated with said candidate code word or words;
- a step of selecting said candidate code word having a zero syndrome, delivering the corrected distinct code word.

**13.** A computer program product executable by a processor, **characterised in that** it comprises programme code instructions for implementing the demodulation method according to at least one of Claims 8 to 12.

**14.** A device for demodulating received symbols, corresponding to symbols modulated after passage in a transmission channel, delivering a reconstructed binary sequence, said modulated symbols being obtained from a source binary sequence formed by a plurality of source words by device processing according to Claim 6, said demodulation device comprising:

- means for differentially demodulating (51) said received symbols, implementing processing that is the inverse of the differential modulation implemented when sending, delivering a demodulated sequence;
- means for de-interlacing (52) said demodulated sequence, implementing processing that is the inverse of the interlacing implemented during sending, delivering a plurality of code words;
- means for decoding (53) said code words, delivering said reconstructed binary sequence.

Fig. 1A

Fig. 1B

Fig. 2

Fig. 5

Fig. 3A

Fig. 3B

Fig. 3C

Fig. 4

Fig. 8A

Fig. 8B

$$\alpha_1 \ \alpha_2 \ \alpha_3 \ \alpha_2 \ \underline{\alpha_2} \ \alpha_4 \ \alpha_2 \ \alpha_3 \ \alpha_4 \ \ldots$$

## Fig. 6

## Fig. 7A

SNR(dB)

## Fig. 7B

SNR(dB)

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 3891959 A

**Littérature non-brevet citée dans la description**

• **J. G. PROAKIS.** Digital Communications. Mc-Graw-Hill, 1989